# EUROPEAN PATENT APPLICATION

(11) **EP 4 682 956 A1**
(43) Date of publication of application: **21.01.2026**
(21) Application number: 25163092.7
(22) Date of filing: 11.03.2025
(51) Int. Cl.: H01L 23/58

(54) **POWER SEMICONDUCTOR DEVICE WITH CRACK PROPAGATION PREVENTION STRUCTURE**

(30) Priority: 19.07.2024 KR 20240095547
(71) Applicant: Samsung Electronics Co., Ltd., Suwon-si, Gyeonggi-do 16677 (KR)
(72) Inventor: PARK, Junhyuk, Suwon-si (KR); HWANG, In Jun, Suwon-si (KR); KIM, Jongseob, Suwon-si (KR); OH, Jaejoon, Suwon-si (KR)
(74) Representative: Marks & Clerk LLP

(57) **Abstract**

Provided is a semiconductor device including a substrate, a channel layer on the substrate and having a first material, a barrier layer located on the channel layer and including a second material having an energy band gap different from that of the first material, a gate electrode located on the barrier layer and extending in a first direction, a gate semiconductor layer located between the barrier layer and the gate electrode, a source electrode connected to the channel layer and spaced apart from the gate electrode in a second direction perpendicular to the first direction, a drain electrode connected to the channel layer and spaced apart from the gate electrode in the second direction in the second direction, and a crack propagation prevention structure located on a side of the source electrode and connected to the source electrode, and penetrating through the channel layer and the barrier layer into the substrate.

## Description

### BACKGROUND

The present disclosure relates to a semiconductor device.

In modern society, semiconductor devices are relied on regularly in daily life. The importance of power semiconductor devices used in various fields such as transportation fields such as electric vehicles, railroads, and electric trams, renewable energy systems such as solar power generation and wind power generation, and mobile devices is gradually increasing. Power semiconductor devices are semiconductor devices used to handle high voltage or high current, and perform functions such as power conversion and control in large power systems or high-output electronic devices. Power semiconductor devices have the ability and durability to handle high power and can handle large amounts of current and withstand high voltage. For example, power semiconductor devices can handle voltages from hundreds of volts to thousands of volts and currents from tens of amperes to thousands of amperes. Power semiconductor devices can improve the efficiency of electrical energy by minimizing power loss. Additionally, power semiconductor devices can be stably driven even in adverse environments such as high temperatures.

These power semiconductor devices can be classified according to materials, and examples include SiC power semiconductor devices and GaN power semiconductor devices. Power semiconductor devices may be manufactured using SiC or GaN instead of existing silicon (Si), and thereby the disadvantage of silicon, which has unstable characteristics at high temperatures, can be compensated for. The SiC power semiconductor devices are resistant to high temperatures and have low power loss, and can be suitable for electric vehicles, renewable energy systems, etc. The GaN power semiconductor devices have high costs, but are efficient in terms of speed and can be suitable for high-speed charging of mobile devices.

### SUMMARY

One aspect of the present disclosure provides a semiconductor device having a source electrode contacting a substrate and having moisture absorption prevention and stress release effects, while preventing damage to and deterioration of the semiconductor device by preventing cracks that may occur when cutting or dicing a semiconductor wafer from being transmitted to the semiconductor device.

A semiconductor device according to one aspect includes a substrate, a channel layer on the substrate, the channel layer including a first material, a barrier layer located on the channel layer and including a second material having an energy band gap different from that of the first material, a gate electrode located on the barrier layer and extending in a first direction parallel to an upper surface of the substrate, a gate semiconductor layer located between the barrier layer and the gate electrode, a source electrode a connected to the channel layer and spaced apart from the gate electrode in a second direction parallel to the upper surface of the substrate and perpendicular to the first direction, a drain electrode connected to the channel layer and spaced apart from the gate electrode in the second direction in the second direction, and a crack propagation prevention structure located on a side of the source electrode and connected to the source electrode, and penetrating through the channel layer and the barrier layer into the substrate.

A semiconductor device according to another aspect includes a substrate, a channel layer on the substrate, the channel layer including a first material, a barrier layer located on the channel layer and including a second material having an energy band gap different from that of the first material, a gate electrode located on the barrier layer and extending in a first direction parallel to an upper surface of the substrate, a gate semiconductor layer located between the barrier layer and the gate electrode, a source electrode connected to the channel layer and spaced apart from the gate electrode in a second direction parallel to the upper surface of the substrate and perpendicular to the first direction, a drain electrode connected to the channel layer and spaced apart from the gate electrode in the second direction, a protective layer covering the gate electrode, a field dispersion layer located on the protective layer, connected to the source electrode, and overlapping the gate electrode in a third direction parallel to the upper surface of the substrate and perpendicular to the second direction, and a crack propagation prevention structure located on a side of the source electrode and connected to the source electrode, and penetrating through the channel layer and the barrier layer into the substrate, wherein the crack propagation prevention structure includes an insulating liner covering opposing side surfaces of the channel layer and a portion of the upper surface of the substrate, and the metal liner is connected to the source electrode and the field dispersion layer.

A semiconductor device according to another aspect includes a substrate, a channel layer on the substrate, the channel layer including a first material, a barrier layer located on the channel layer and including a second material having an energy band gap different from that of the first material, a gate electrode located on the barrier layer and extending in a first direction parallel to an upper surface of the substrate, a gate semiconductor layer located between the barrier layer and the gate electrode, a source electrode connected to the channel layer and spaced apart from the gate electrode in a second direction parallel to the upper surface of the substrate and perpendicular to the first direction, a drain electrode connected to the channel layer and spaced apart from the gate electrode in the second direction, and a crack propagation prevention structure located on a side of the source electrode and connected to the source electrode, and connected to the substrate penetrating the channel layer and the barrier layer, wherein the crack propagation prevention structure includes an insulating liner covering side surfaces of the channel layer and a portion of the upper surface of the substrate, and the semiconductor device further includes a metal silicide layer between the substrate and the metal liner of the crack propagation prevention structure.

The crack propagation prevention structure of a semiconductor device according to embodiments prevents cracks that may occur when cutting or dicing a semiconductor wafer from being transmitted to the semiconductor device, thereby preventing damage to and deterioration of the semiconductor device, can also be used as a substrate contact, and has moisture absorption prevention and stress release effects.

At least some of the above and other features of the invention are set out in the claims.

### BRIEF DESCRIPTION OF THE DRAWINGS

FIG. 1 is a plan view showing a substrate including a scribe lane area.
FIGS. 2 to 4 are plan views showing semiconductor devices according to embodiments.
FIG. 5 is a cross-sectional view taken along line A-A' of FIG. 4.
FIG. 6 is an enlarged cross-sectional view of the outer area of FIG. 5.
FIG. 7 is a cross-sectional view taken along line A-A' of FIG. 4, showing another embodiment.
FIG. 8 is a cross-sectional view taken along line A-A' of FIG. 4, showing another embodiment.
FIGS. 9 to 20 are cross-sectional views showing a method of manufacturing a semiconductor device according to process sequence, according to an embodiment.

### DETAILED DESCRIPTION OF THE EMBODIMENTS

Hereinafter, the present disclosure will be described more fully hereinafter with reference to the accompanying drawings, in which example embodiments are shown. As those skilled in the art would realize, the described embodiments may be modified in various different ways, all without departing from the scope of the present disclosure.

The drawings and description are to be regarded as illustrative in nature and not restrictive. Like reference numerals designate like elements throughout the specification. Items described in the singular herein may be provided in plural, as can be seen, for example, in the drawings. Thus, the description of a single item provided in plural should be understood to be applicable to the remaining plurality of items unless context indicates otherwise.

The size and thickness of each constituent element as shown in the drawings are randomly indicated for better understanding and ease of description, and the inventive concept is not necessarily limited to as shown. In the drawings, the thickness of layers, regions, etc., are exaggerated for clarity. In addition, in the drawings, for better understanding and ease of description, the thickness of some layers and areas is exaggerated. Additionally, when the terms "about" or "substantially" are used in this specification in connection with a numerical value and/or geometric terms, it is intended that the associated numerical value includes a manufacturing tolerance (e.g., ±10%) around the stated numerical value. Further, where any numerical value is specified in conjunction with "about" or "substantially", the numerical value without modification by "about" or "substantially" is also covered. Further, regardless of whether numerical values and/or geometric terms are modified as "about" or "substantially," it will be understood that these values should be construed as including a manufacturing or operational tolerance (e.g., ±10%) around the stated numerical values and/or geometry.

It will be understood that when an element is referred to as being "on" another element, it can be directly connected or coupled to or on the other element or intervening elements may be present. In contrast, when an element is referred to as being "directly connected" or "directly coupled" to another element, or as "contacting" or "in contact with" another element (or using any form of the word "contact"), there are no intervening elements present at the point of contact. It will be understood that when an element such as a layer, film, region, or substrate is referred to as being "connected" or "coupled" to or "on" another element, it can be directly connected or coupled to or on the other element or intervening elements may also be present. In contrast, when an element is referred to as being In contrast, when an element is referred to as being "directly connected" or "directly coupled" to another element, or as "contacting" or "in contact with" another element (or using any form of the word "contact"), there are no intervening elements present at a point of contact. The word "on" or "above" means being disposed on or below the object portion, and does not necessarily mean being disposed on the upper side of the object portion based on a gravitational direction.

As used herein, components described as being "electrically connected" are configured such that an electrical signal can be transferred from one component to the other (although such electrical signal may be attenuated in strength as it is transferred and may be selectively transferred). Moreover, components that are "directly electrically connected" form a common electrical node through electrical connections by one or more conductors, such as, for example, wires, pads, internal electrical lines, through vias, etc. As such, directly electrically connected components do not include components electrically connected through active elements, such as transistors or diodes.

In addition, unless explicitly described to the contrary, the word "comprise," and variations such as "comprises" or "comprising," will be understood to imply the inclusion of stated elements but not the exclusion of any other elements.

Throughout the specification, when a component is described as "including" a particular element or group of elements, it is to be understood that the component may be formed of only the element or the group of elements, or the element or group of elements may be combined with additional elements to form the component, unless the context indicates otherwise. The term "consisting of," on the other hand, indicates that a component is formed only of the element(s) listed.

Ordinal numbers such as "first," "second," "third," etc. may be used simply as labels of certain elements, steps, etc., to distinguish such elements, steps, etc. from one another. Terms that are not described using "first," "second," etc., in the specification, may still be referred to as "first" or "second" in a claim. In addition, a term that is referenced with a particular ordinal number (e.g., "first") in a particular claim may be described elsewhere with a different ordinal number (e.g., "second") in the specification or another claim.

An item, layer, or portion of an item or layer described as extending "lengthwise" in a particular direction has a length in the particular direction and a width perpendicular to that direction, where the length is greater than the width.

In addition, in this specification, the phrase "on a plane" means viewing a target portion from the top, and the phrase "on a cross-section" means viewing a cross-section formed by vertically cutting a target portion from the side.

In addition, throughout the specification, two directions parallel to the upper surface of the substrate and intersecting one another are referred to as the first direction D1 and the second direction D2, respectively, and the direction perpendicular to the upper surface of the substrate is referred to as the third direction D3. For example, the first direction D1 and the second direction D2 may be perpendicular to each other. The third direction D3 may define a vertical (or height) direction of the semiconductor device. Certain features described as "above" other features may be located further along the third direction D3 than the other features. Similarly, "upper" features may be located above "lower" features. It will be appreciated that these terms are relative to the structure of the semiconductor device, and need not imply any particular orientation of the semiconductor device in use.

As used herein, the terms "material continuity" and "materially in continuity" may refer to structures, patterns, and/or layers that are formed at the same time and of the same material (e.g., formed simultaneously in the same process), without a break in the continuity of the material of which they are formed. As one example, structures, patterns, and/or layers that are in "material continuity" or "materially in continuity" may be homogeneous monolithic structures. As such, a boundary between the structures, patterns, and/or layers may not be apparent.

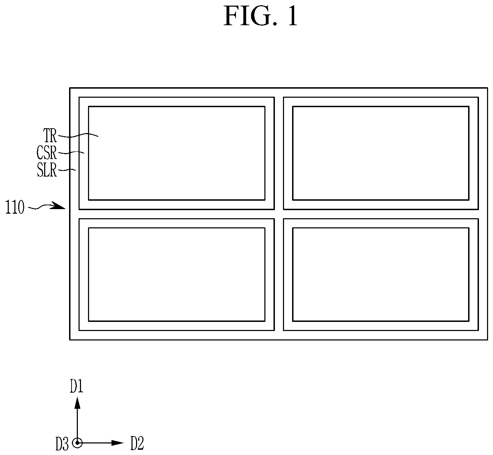

FIG. 1 is a plan view showing a substrate including a scribe lane region. The scribe lane region may comprise areas of a wafer in which no circuits (e.g., no transistors) are formed and/or no circuits (e.g., no transistors) are formed that are part of the integrated circuits of the undiced chips formed on the wafer.

The substrate 110 may have a plurality of transistor regions TRs, a plurality of outer regions CSRs surrounding each of the transistor regions TRs, and a plurality of scribe lane regions SLRs between the transistor regions TRs.

Transistors may be located within the transistor regions TRs. For example, the transistors arranged within the transistor regions TRs may be gallium nitride-based high electron mobility transistors (HEMTs).

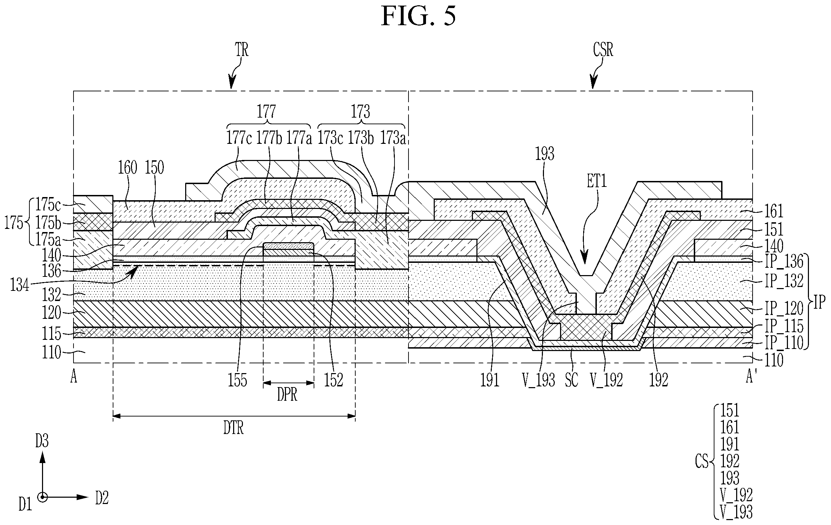

The outer regions CSRs may each surround a respective transistor region TR. For example, an outer region CSR may be located between a transistor region TR and the scribe lane region SLR. The outer region CSR may be provided with a crack propagation prevention structure (CS in FIG. 5) as described below.

The transistor regions TRs may be partitioned by scribe lane regions SLRs. For example, the scribe lane regions SLRs may each individually surround a respective transistor region TR. The transistor regions TRs may have a rectangular or square shape. The transistor regions TRs may be arranged in rows and columns with equal spacing. A portion of the scribe lane regions SLR that partitions the transistor regions TRs may have a cross shape. For example, the scribe lane regions SLRs may have a rectangular frame shape that individually surrounds each of the transistor regions TRs.

The substrate 110 may be cut or diced into individual dies along the scribe lane regions SLRs located between the transistor regions TRs. When cutting or dicing the substrate 110, a crack may occur, and the crack may propagate to the transistor region TR, damaging the semiconductor device.

In a semiconductor device according to an embodiment, a crack propagation prevention structure CS located in an outer region CSR surrounding a transistor region TR can prevent a crack, which may occur when cutting or dicing a substrate 110 along a scribe lane region SLR, from propagating into the semiconductor device, thereby preventing damage to the semiconductor device and deterioration of its performance.

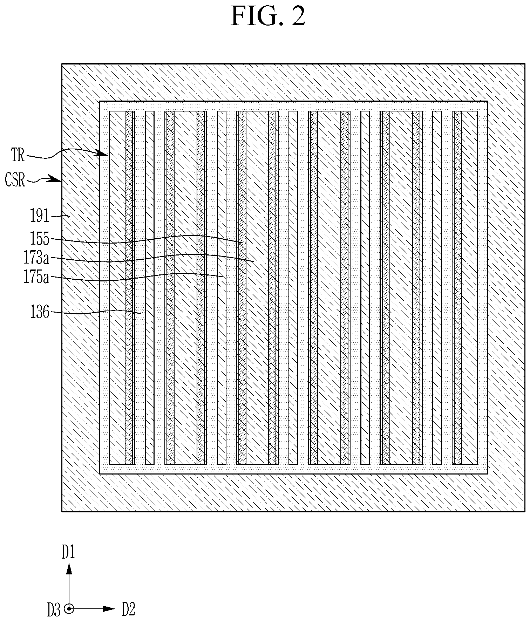

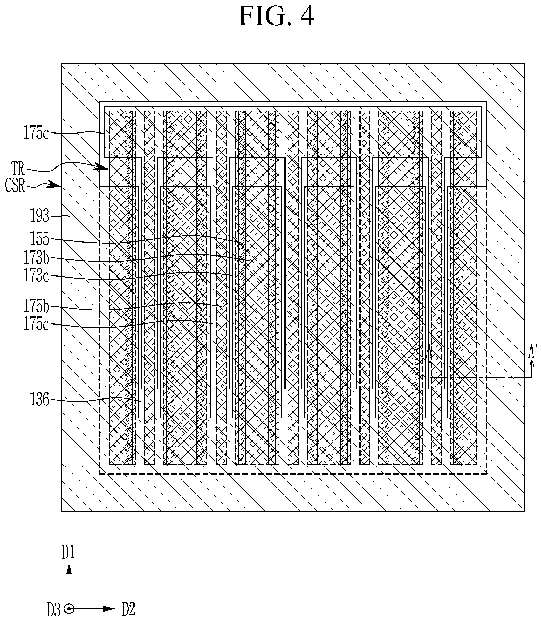

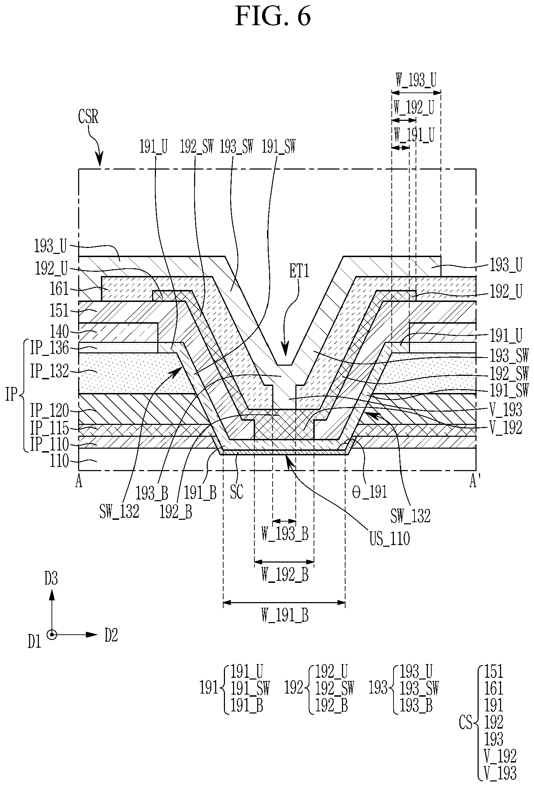

FIGS. 2 to 4 are plan views showing semiconductor devices according to embodiments. FIG. 5 is a cross-sectional view taken along line A-A' of FIG. 4. FIG. 6 is an enlarged cross-sectional view of the outer region CSR of FIG. 5.

For a clear understanding and simple illustration, FIG. 2 illustrates a barrier layer 136, a gate electrode 155, a lower source electrode 173a, a lower drain electrode 175a of the transistor region TR, and a first metal liner 191 of the outer region CSR, and the description of other elements may be omitted.

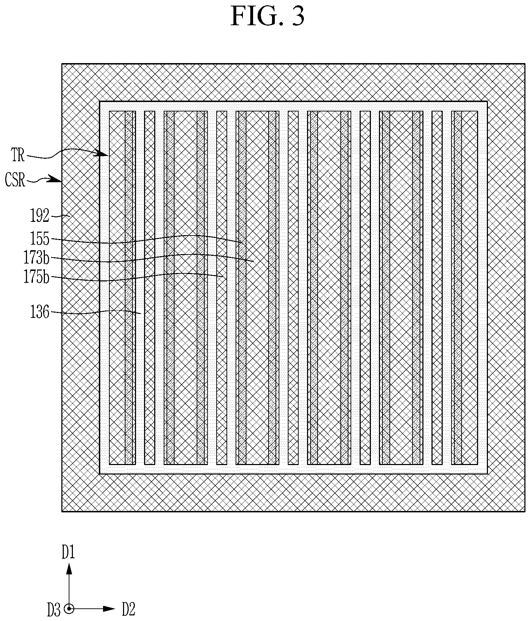

In FIG. 3, the barrier layer 136, the gate electrode 155, an intermediate source electrode 173b, an intermediate drain electrode 175b of the transistor region TR, and a second metal liner 192 of the outer region CSR are illustrated, and the description of other elements may be omitted.

In FIG. 4, the barrier layer 136, the gate electrode 155, the intermediate source electrode 173b, an upper source electrode 173c, the intermediate drain electrode 175b, an upper drain electrode 175c of the transistor region TR, and a third metal liner 193 of the outer region CSR are illustrated, and other elements may be omitted. In FIG. 4, the third metal liner 193 is illustrated as surrounding the entire transistor region TR in the outer region CSR, but this is not limited thereto, and the third metal liner 193 may be located only in a part of the outer region CSR.

Referring to FIGS. 2 to 6, the semiconductor device includes a substrate 110, a channel layer 132 located on a transistor region TR of the substrate 110, a barrier layer 136 located on the channel layer 132, a gate electrode 155 located on the barrier layer 136, a gate semiconductor layer 152 located between the barrier layer 136 and the gate electrode 155, and a source electrode (e.g., the lower source electrode 173a, the intermediate source electrode 173b, or the upper source electrode 173c which may be collectively referred to a source electrode 173) and a drain electrode (e.g., the lower drain electrode 175a, the intermediate drain electrode 175b, or the upper drain electrode 175c which may be collectively referred to as a drain electrode 175) located on both sides of the gate electrode 155 and connected to the channel layer 132.

The channel layer 132 is a layer that forms a channel between the source electrode 173 and the drain electrode 175 and a two-dimensional electron gas (2DEG, 2-dimensional electron gas) 134 may be located inside the channel layer 132. The two-dimensional electron gas 134 refers to a group of electrons that can move freely in two dimensions (e.g., in a D1-D2 plane direction) as characterized by a charge transport model used in solid physics, but cannot move and are tightly bound in another dimension (e.g., in a D3 direction). For example, the two-dimensional electron gas 134 may exist in a two-dimensional paper-like form (e.g., planar) within a three-dimensional space. This two-dimensional electron gas 134 mainly appears in a semiconductor heterojunction structure, and may occur at the interface between the channel layer 132 and the barrier layer 136 in the semiconductor device according to an embodiment. For example, the two-dimensional electron gas 134 may be generated in the portion of the channel layer 132 closest to the barrier layer 136.

The channel layer 132 may include nitride including Group III-V materials, for example, Al, Ga, In, B, or a combination thereof. The channel layer 132 may be made of a single layer or multiple layers. As an example, the channel layer 132 may include AlₓIn_{y}Ga_{1-x-y}N (0≤x≤1, 0≤y≤1, x+y≤1). For example, the channel layer 132 may include AIN, GaN, InN, InGaN, AlGaN, AlInN, AlInGaN, or a combination thereof. The channel layer 132 may be a layer doped with impurities or a layer undoped with impurities. A thickness of the channel layer 132 may be several hundred nm or less.

The channel layer 132 may be located on the substrate 110, and a seed layer 115 and/or a buffer layer 120 may be located between the substrate 110 and the channel layer 132. The substrate 110, the seed layer 115, and the buffer layer 120 may be layers used to form the channel layer 132, and may be omitted in some cases. For example, when a substrate made of GaN is used as the channel layer 132, at least one of the substrate 110, the seed layer 115, and the buffer layer 120 may be omitted. Considering that the price of a substrate made of GaN is relatively high, the channel layer 132 including GaN can be grown using a substrate 110 made of Si. Since the lattice structure of Si and GaN are different, it may be difficult to grow the channel layer 132 directly on the substrate 110. Accordingly, the seed layer 115 and the buffer layer 120 can be first grown on the substrate 110, and then the channel layer 132 can be grown on the buffer layer 120. Additionally, at least one of the substrate 110, the seed layer 115, and the buffer layer 120 may be removed from the final structure of the semiconductor device after being used in the manufacturing process.

The substrate 110 may include a semiconductor material. For example, the substrate 110 may include sapphire, Si, SiC, AIN, GaN, or a combination thereof. The substrate 110 may be a silicon on insulator (SOI) substrate. However, the material of the substrate 110 is not limited to this, and any commonly used substrate can be applied. In some cases, the substrate 110 may include an insulating material. For example, several layers, including the channel layer 132, may be first formed on a semiconductor substrate, then the semiconductor substrate may be removed and replaced with an insulating substrate.

The seed layer 115 may be located on the substrate 110. The seed layer 115 may be located directly on the substrate 110. However, it is not limited to this, and another predetermined layer may be further located between the substrate 110 and the seed layer 115. The seed layer 115 is a layer that serves as a seed for growing the buffer layer 120, and may be made of a crystal lattice structure that serves as a seed for the buffer layer 120. For example, the seed layer 115 may include AIN, but is not limited thereto.

The buffer layer 120 may be located on the seed layer 115. The buffer layer 120 may be located directly on the seed layer 115. However, it is not limited to this, and another predetermined layer may be further located between the seed layer 115 and the buffer layer 120. The buffer layer 120 may be located between the seed layer 115 and the channel layer 132. The buffer layer 120 may include nitride including Group III-V materials, for example, Al, Ga, In, B, or a combination thereof. The buffer layer 120 may include AlₓIn_{y}Ga_{1-x-y}N (0≤x≤1, 0≤y≤1, x+y≤1). For example, the buffer layer 120 may include AIN, GaN, InN, InGaN, AlGaN, AlInN, AlInGaN, or a combination thereof. The buffer layer 120 may be made of a single layer or multiple layers. For example, the buffer layer 120 may include a superlattice layer and a high-resistance layer.

The superlattice layer alleviates a difference in lattice constant and thermal expansion coefficient between the substrate 110 and the channel layer 132, thereby relieving tensile stress and compressive stress generated between the substrate 110 and the channel layer 132. According to some embodiments, the high-resistance layer may be used to prevent the semiconductor device from being deteriorated by preventing leakage current from flowing through the channel layer 132. To this end, the high-resistance layer may be made of a low-conductivity material to electrically insulate the substrate 110 and the channel layer 132.

The barrier layer 136 may be located on the channel layer 132. The barrier layer 136 may be located directly on the channel layer 132. However, it is not limited to this, and another predetermined layer may be further located between the channel layer 132 and the barrier layer 136. A region of the channel layer 132 that is overlapped with the barrier layer 136 may be a drift region DTR. The drift region DTR may be located between the source electrode 173 and the drain electrode 175. When a potential difference occurs between the source electrode 173 and the drain electrode 175, carriers may move in the drift region DTR. The semiconductor device may be turned on/off depending on whether a voltage is applied to the gate electrode 155 and the magnitude of the voltage applied to the gate electrode 155. When a voltage greater than the threshold voltage is applied to the gate electrode 155 and the semiconductor device is turned on, a channel may be created in the depletion region DPR. Accordingly, movement of the carrier may occur in the drift region DTR. If a voltage lower than the threshold voltage is applied to the gate electrode 155 or no voltage is applied, the channel path may be blocked in the depletion region DPR and carrier movement may not occur.

The barrier layer 136 may include nitride including Group III-V materials, for example, Al, Ga, In, B, or a combination thereof. The barrier layer 136 may include AlₓIn_{y}Ga_{1-x-y}N (0≤x≤1, 0≤y≤1, x+y≤1). For example, the barrier layer 136 may include AIN, GaN, InN, InGaN, AlGaN, AlInN, AlInGaN, or a combination thereof. The energy band gap of the barrier layer 136 can be adjusted by a composition ratio of Al or In. The barrier layer 136 may be doped with a predetermined impurity. In some examples, the impurity doped into the barrier layer 136 may be a p-type dopant that can provide holes. For example, the impurity doped into the barrier layer 136 may be magnesium (Mg). By increasing or decreasing the impurity doping concentration of the barrier layer 136, the threshold voltage, on-resistance, etc. of the semiconductor device can be adjusted.

The barrier layer 136 may include a semiconductor material having different characteristics from the channel layer 132. The barrier layer 136 may be different from the channel layer 132 in at least one of polarization characteristics, energy bandgap, and lattice constant. For example, the barrier layer 136 may include a material having a different energy bandgap than the channel layer 132. The barrier layer 136 may have a higher energy bandgap than the channel layer 132 and may have a higher electrical polarization rate than the channel layer 132. The two-dimensional electron gas 134 may be induced in the channel layer 132, which has a relatively low electrical polarization rate, by the barrier layer 136. In this regard, the barrier layer 136 may also be called a channel supply layer or a two-dimensional electron gas supply layer. The two-dimensional electron gas 134 may be formed within the portion of the channel layer 132 under the interface between the channel layer 132 and the barrier layer 136. The two-dimensional electron gas 134 may have very high electron mobility.

The gate electrode 155 may be located on the barrier layer 136. The gate electrode 155 may be overlapped with a portion of the barrier layer 136 in the third direction D3. The gate electrode 155 may be overlapped with a portion of the drift region DTR of the channel layer 132 in the third direction D3. The gate electrode 155 may be located between the source electrode 173 and the drain electrode 175 in the second direction D2. The gate electrode 155 may be spaced apart from the source electrode 173 and the drain electrode 175 in the second direction D2. The gate electrode 155 may extend along the first direction D1 on a plane. For example, the gate electrode 155 may have a bar shape extending long along the first direction D1 on a plane.

The gate electrode 155 may include a conductive material. For example, the gate electrode 155 may include a metal, a metal alloy, conductive metal nitride, metal silicide, a doped semiconductor material, conductive metal oxide, or conductive metal oxynitride. For example, the gate electrode 155 may be made of titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAlN), tantalum aluminum nitride (TaAIN), tungsten nitride (WN), ruthenium (Ru), titanium aluminum (TiAl), titanium aluminum carbonitride (TiAlC-N), titanium aluminum carbide (TiAIC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt) , nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium. (Rh), palladium (Pd), iridium (Ir), osmium (Os), silver (Ag), gold (Au), zinc (Zn), vanadium (V), or a combination thereof, but is not limited thereto. The gate electrode 155 may be made of a single layer or multiple layers.

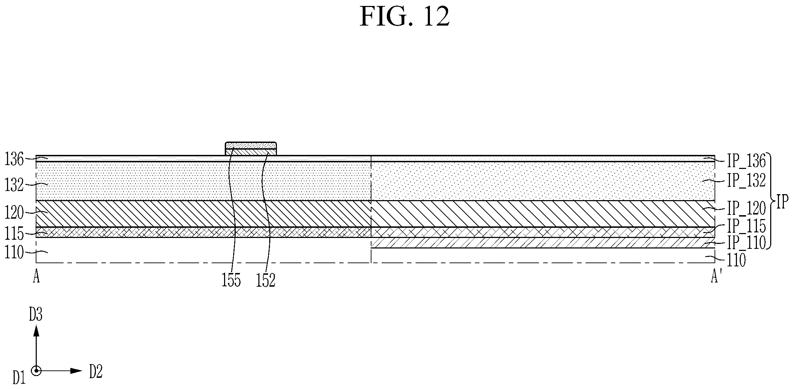

In some embodiments, the semiconductor device may further include a hard mask layer (not shown) on the gate electrode 155. The hard mask layer may be used as a hard mask when patterning the gate electrode material layer 155_L or the gate semiconductor material layer 152_L, as described later in FIG. 12. However, the hard mask layer may be removed depending on the etching conditions during the etching of the gate semiconductor or depending on the cleaning conditions after etching. For example, the hard mask layer may include silicon oxide, silicon nitride, silicon oxynitride, or a combination thereof.

The gate semiconductor layer 152 is located between the barrier layer 136 and the gate electrode 155. For example, the gate semiconductor layer 152 may be located on the barrier layer 136, and the gate electrode 155 may be located on the gate semiconductor layer 152. The gate electrode 155 may be in Schottky contact with the gate semiconductor layer 152. However, it is not limited to this, and in some cases, the gate electrode 155 may be in ohmic contact with the gate semiconductor layer 152. The gate semiconductor layer 152 may be overlapped with the gate electrode 155 in the third direction D3. The upper surface of the gate semiconductor layer 152 may be entirely covered by the gate electrode 155.

The gate semiconductor layer 152 may be located between the source electrode 173 and the drain electrode 175 in the second direction D2. The gate semiconductor layer 152 may be spaced apart from the source electrode 173 and the drain electrode 175 in the second direction D2. The gate semiconductor layer 152 may be located closer to the source electrode 173 than the drain electrode 175. For example, a separation distance between the gate semiconductor layer 152 and the source electrode 173 may be smaller than a separation distance between the gate semiconductor layer 152 and the drain electrode 175.

The gate semiconductor layer 152 may include nitride including Group III-V materials, for example, Al, Ga, In, B, or a combination thereof. The gate semiconductor layer 152 may include AlₓIn_{y}Ga_{1-x-y}N (0≤x≤1, 0≤y≤1, x+y≤1). For example, the gate semiconductor layer 152 may include AIN, GaN, InN, InGaN, AlGaN, AlInN, AlInGaN, or a combination thereof. The gate semiconductor layer 152 may include a material having an energy bandgap different from that of the barrier layer 136. For example, the gate semiconductor layer 152 may include GaN, and the barrier layer 136 may include AlGaN. The gate semiconductor layer 152 may be doped with a predetermined impurity. In some examples, the impurity doped into the gate semiconductor layer 152 may be a p-type dopant that can provide holes. For example, the gate semiconductor layer 152 may include GaN doped with p-type impurities. The gate semiconductor layer 152 may be made of a p-GaN layer. However, it is not limited to this, and the gate semiconductor layer 152 may be a p-AlGaN layer. The impurity doped into the gate semiconductor layer 152 may be magnesium (Mg). The gate semiconductor layer 152 may be made of a single layer or multiple layers.

A depletion region DPR may be formed in the channel layer 132 by the gate semiconductor layer 152. The depletion region DPR may be located within the drift region DTR and may have a narrower width than the drift region DTR (e.g. in the second direction D2). As the gate semiconductor layer 152 having a different energy bandgap from the barrier layer 136 is located on the barrier layer 136, a level of the energy band of a portion of the barrier layer 136 that is overlapped with the gate semiconductor layer 152 may increase. Accordingly, the depletion region DPR may be formed in the area of the channel layer 132 that is overlapped with the gate semiconductor layer 152. The depletion region DPR may be a region in the channel path of the channel layer 132 where the two-dimensional electron gas 134 is not formed or may have a lower electron concentration than the remaining regions. The depletion region DPR may refer to a region where the flow of the two-dimensional electron gas 134 is interrupted within the drift region DTR. As the depletion region DPR is generated, current does not flow between the source electrode 173 and the drain electrode 175, and the channel path may be blocked. Accordingly, the semiconductor device may have normally-off characteristics.

The semiconductor device may be a normally-off semiconductor device (HEMT, High Electron Mobility Transistor). In a normal state in which no voltage is applied to the gate electrode 155, a depletion region DPR exists and the semiconductor device may be in an off state. Although not shown, when a voltage higher than the threshold voltage is applied to the gate electrode 155, the depletion region DPR disappears, and the two-dimensional electron gas 134 may be connected without being disconnected within the drift region DTR. For example, the two-dimensional electron gas 134 may be formed throughout the channel path between the source electrode 173 and the drain electrode 175, and the semiconductor device may be in an on state. In summary, the semiconductor device may include semiconductor layers with different electrical polarization characteristics, and a semiconductor layer with a relatively high polarization rate can induce two-dimensional electron gas 134 in another semiconductor layer that forms heterojunction therewith. This two-dimensional electron gas 134 can be used as a channel between the source electrode 173 and the drain electrode 175, and the continuation or interruption of the flow of the two-dimensional electron gas 134 can be controlled by the bias voltage applied to the gate electrode 155. In the gate-off state, the flow of the two-dimensional electron gas 134 is blocked, and thus current may not flow between the source electrode 173 and the drain electrode 175. In the gate-on state, the two-dimensional electron gas 134 continues to flow, and thus current may flow between the source electrode 173 and the drain electrode 175.

Although the case where the semiconductor device is a normally-off high electron mobility transistor has been described above, the present disclosure is not limited thereto. For example, the semiconductor device may be a normally-on high electron mobility transistor. In the case of a normally-on high electron mobility transistor, the gate semiconductor layer 152 may be omitted, and accordingly, the gate electrode 155 may be located directly on the barrier layer 136. For example, the gate electrode 155 may contact the barrier layer 136. In this structure, the two-dimensional electron gas 134 can be used as a channel while no voltage is applied to the gate electrode 155, and current may flow between the source electrode 173 and the drain electrode 175. Additionally, when a negative voltage is applied to the gate electrode 155, a depletion region DPR in which the flow of the two-dimensional electron gas 134 is cut off may be generated at the bottom of the gate electrode 155.

The buffer layer 120, channel layer 132, barrier layer 136, and gate semiconductor layer 152 described above may be sequentially stacked on the substrate 110. In the semiconductor device, at least one of the buffer layer 120, the channel layer 132, the barrier layer 136, and the gate semiconductor layer 152 may be omitted. The buffer layer 120, channel layer 132, barrier layer 136, and gate semiconductor layer 152 may be made of the same semiconductor material, and considering the role of each layer and the performance required for the semiconductor device, a material composition ratio of each layer may be different.

The semiconductor device may further include first to third protective layers 140, 150, and 160 on the barrier layer 136 and the gate electrode 155. As an example, the semiconductor device may include a first protective layer 140, a second protective layer 150 on the first protective layer 140, and a third protective layer 160 on the second protective layer 150. The first protective layer 140 may cover the upper surface of the barrier layer 136 and the gate electrode 155, and may cover the side surface of the gate electrode 155 and the side surface of the gate semiconductor layer 152. The lower surface of the first protective layer 140 may be in contact with the barrier layer 136, the gate electrode 155, and the gate semiconductor layer 152. The upper surface of the first protective layer 140 may be in contact with the second protective layer 150. The second and third protective layers 150 and 160 may be spaced apart from the barrier layer 136, the gate electrode 155, and the gate semiconductor layer 152 by the first protective layer 140. Accordingly, the second and third protective layers 150 and 160 may not contact the barrier layer 136, the gate electrode 155, and the gate semiconductor layer 152.

The barrier layer 136 or the gate electrode 155 may be protected by the first to third protective layers 140, 150, and 160 and may be separated from other components. The first to third protective layers 140, 150, and 160 may include an insulating material. For example, the first to third protective layers 140, 150, and 160 may include an oxide such as SiO₂ or Al₂O₃. As another example, the first to third protective layers 140, 150, and 160 may include a nitride such as SiN or oxynitride such as SiON. The first to third protective layers 140, 150, and 160 may include the same material or different materials. If the first to third protective layers 140, 150, and 160 are made of the same material, boundaries between the first to third protective layers 140, 150, and 160 may not be visible. The first to third protective layers 140, 150, and 160 may each be made of a single layer or multiple layers.

The source electrode 173 and the drain electrode 175 may be located on the channel layer 132. The source electrode 173 and the drain electrode 175 may be spaced apart from each other in the second direction D2, and the gate electrode 155 and the gate semiconductor layer 152 may be located between the source electrode 173 and the drain electrode 175. The gate electrode 155 and the gate semiconductor layer 152 may be spaced apart from the source electrode 173 and the drain electrode 175 in the second direction D2. The source electrode 173 may be electrically connected to the channel layer 132 on one side of the gate electrode 155 in the second direction D2. The drain electrode 175 may be electrically connected to the channel layer 132 on the other side of the gate electrode 155 in the second direction D2. The source electrode 173 and the drain electrode 175 may be located outside the drift region DTR of the channel layer 132. The boundary between the source electrode 173 and the channel layer 132 may be one edge of the drift region DTR. Likewise, the boundary between the drain electrode 175 and the channel layer 132 may be the other edge of the drift region DTR. However, the present disclosure is not limited thereto, and the source electrode 173 and the drain electrode 175 may not be located outside the drift region DTR of the channel layer 132. The channel layer 132 may not be recessed, and the source electrode 173 and the drain electrode 175 may be located on the upper surface of the channel layer 132. The lower surfaces of the source electrode 173 and the drain electrode 175 may contact the upper surface of the channel layer 132. A portion of the channel layer 132 in contact with the source electrode 173 and the drain electrode 175 may be doped at a high concentration. The carriers passing through the two-dimensional electron gas 134 may pass through the highly doped channel layer 132 (e.g., may be transmitted to the source electrode 173 and the drain electrode 175 through the upper of the two-dimensional electron gas 134). The source electrode 173 and the drain electrode 175 may not directly contact the two-dimensional electron gas 134 in the horizontal direction. The horizontal direction may refer to a direction parallel to the upper surface of the channel layer 132 or the barrier layer 136.

The source electrode 173 and the drain electrode 175 may each extend along the first direction D1 on a plane. For example, each of the source electrode 173 and the drain electrode 175 may have a rod shape extending lengthwise along the first direction D1 on a plane. The source electrode 173 and the drain electrode 175 may extend in parallel directions. The source electrode 173 and the drain electrode 175 may extend in a direction parallel to the gate electrode 155.

The source electrode 173 and the drain electrode 175 may include a conductive material. For example, the source electrode 173 and the drain electrode 175 may include a metal, a metal alloy, conductive metal nitride, metal silicide, a doped semiconductor material, conductive metal oxide, or conductive metal oxynitride. For example, the source electrode 173 and the drain electrode 175 may be made of titanium nitride (TiN), tantalum carbide (TaC), tantalum nitride (TaN), titanium silicon nitride (TiSiN), tantalum silicon nitride (TaSiN), tantalum titanium nitride (TaTiN), titanium aluminum nitride (TiAIN), tantalum aluminum nitride (TaAlN), tungsten nitride (WN), ruthenium (Ru), titanium aluminum (TiAl), titanium aluminum carbonitride (TiAIC-N), titanium aluminum carbide (TiAlC), titanium carbide (TiC), tantalum carbonitride (TaCN), tungsten (W), aluminum (Al), copper (Cu), cobalt (Co), titanium (Ti), tantalum (Ta), nickel (Ni), platinum (Pt) , nickel platinum (Ni-Pt), niobium (Nb), niobium nitride (NbN), niobium carbide (NbC), molybdenum (Mo), molybdenum nitride (MoN), molybdenum carbide (MoC), tungsten carbide (WC), rhodium. (Rh), palladium (Pd), iridium (Ir), osmium (Os), silver (Ag), gold (Au), zinc (Zn), vanadium (V), or a combination thereof, but are not limited thereto. The source electrode 173 and the drain electrode 175 may be made of a single layer or multiple layers. The source electrode 173 and the drain electrode 175 may be in ohmic contact with the channel layer 132. A region in contact with the source electrode 173 and the drain electrode 175 within the channel layer 132 may be doped at a relatively high concentration compared to other regions.

The source electrode 173 may include the lower source electrode 173a, the intermediate source electrode 173b, and the upper source electrode 173c. The intermediate source electrode 173b may be located on the lower source electrode 173a. The upper source electrode 173c may be located on the intermediate source electrode 173b. The lower source electrode 173a may be in contact with the channel layer 132 and may be electrically connected (e.g. directly electrically connected) to the channel layer 132. The intermediate source electrode 173b and the upper source electrode 173c may not be in contact with the channel layer 132, and may be electrically connected to the channel layer 132 through the lower source electrode 173a.

The drain electrode 175 may include the lower drain electrode 175a, the intermediate drain electrode 175b, and the upper drain electrode 175c. The intermediate drain electrode 175b may be located on the lower drain electrode 175a. The upper drain electrode 175c may be located on the intermediate drain electrode 175b. The lower drain electrode 175a may be in contact with the channel layer 132 and may be electrically connected (e.g. directly electrically connected) to the channel layer 132. The intermediate drain electrode 175b and the upper drain electrode 175c may not be in contact with the channel layer 132, and may be electrically connected to the channel layer 132 through the lower drain electrode 175a.

The upper surfaces of the lower source electrode 173a and the lower drain electrode 175a may be located at level(s) above the first protective layer 140. The upper surfaces of the lower source electrode 173a and the lower drain electrode 175a may be located at level(s) between the first protective layer 140 and the second protective layer 150. The lower source electrode 173a and the lower drain electrode 175a penetrate the first protective layer 140 and the barrier layer 136, and the trenches recessing the upper surface of the channel layer 132 may be located on both sides of the gate electrode 155 to be spaced apart from each other. The lower source electrode 173a and the lower drain electrode 175a may be located in the trench on both sides of the gate electrode 155, respectively. The lower source electrode 173a and the lower drain electrode 175a may be formed to fill the trench. Within the trench, the lower source electrode 173a and the lower drain electrode 175a may contact the channel layer 132 and the barrier layer 136. The channel layer 132 may form the bottom and side walls of the trench, and the barrier layer 136 may form the side walls of the trench. Accordingly, the lower source electrode 173a and the lower drain electrode 175a may contact the upper surface and side surfaces of the channel layer 132. Additionally, the lower source electrode 173a and the lower drain electrode 175a may contact the side surface of the barrier layer 136. For example, the lower source electrode 173a and the lower drain electrode 175a may cover the side surfaces of the channel layer 132 and the barrier layer 136. The upper surfaces of the lower source electrode 173a and the lower drain electrode 175a may protrude from the upper surface of the first protective layer 140. Additionally, at least one of the lower source electrode 173a and the lower drain electrode 175a may cover at least a portion of the upper surface of the first protective layer 140. A second protective layer 150 may be located on the lower source electrode 173a and the lower drain electrode 175a. At least a portion of the lower source electrode 173a and the lower drain electrode 175a may be covered by the second protective layer 150.

The semiconductor device may further include a first field dispersion layer 177a on the first protective layer 140. The first field dispersion layer 177a may be located between the source electrode 173 and the drain electrode 175. The first field dispersion layer 177a may be overlapped with the gate electrode 155 in the third direction D3. The gate electrode 155 may be covered by a first field dispersion layer 177a. The first field dispersion layer 177a may be electrically connected to the source electrode 173. For example, the first field dispersion layer 177a may be connected to the lower source electrode 173a. The first field dispersion layer 177a may include the same material as the lower source electrode 173a and may be located in the same layer as the lower source electrode 173a. The first field dispersion layer 177a may be formed simultaneously with the lower source electrode 173a in the same process. The boundary between the first field dispersion layer 177a and the lower source electrode 173a may not be apparent, and the first field dispersion layer 177a may be formed integrally with the lower source electrode 173a. However, the present disclosure is not limited thereto, and the first field dispersion layer 177a may be a separate element from the lower source electrode 173a. Additionally, the first field dispersion layer 177a may be located in a different layer from the lower source electrode 173a and may be formed in a different process. In some cases, the first field dispersion layer 177a may be electrically connected to the gate electrode 155. For example, an opening that is overlapped with the gate electrode 155 may be formed in the first protective layer 140, and the first field dispersion layer 177a may be connected to the gate electrode 155 through the opening. In some examples, the first field dispersion layer 177a may not be connected to the source electrode 173.

The semiconductor device may further include a second field dispersion layer 177b located on the second protective layer 150. The second field dispersion layer 177b may form a field dispersion layer together with the first field dispersion layer 177a. The second field dispersion layer 177b may be located between the source electrode 173 and the drain electrode 175. The second field dispersion layer 177b may be overlapped with the gate electrode 155 in the third direction D3. The second field dispersion layer 177b may be overlapped with the first field dispersion layer 177a in the third direction D3. The gate electrode 155 and the first field dispersion layer 177a may be covered by the second field dispersion layer 177b. The second field dispersion layer 177b may be wider (e.g. in the second direction D2) than the first field dispersion layer 177a. The second field dispersion layer 177b may entirely cover the first field dispersion layer 177a. However, the present disclosure is not limited thereto, and the width and positional relationship of the first field dispersion layer 177a and the second field dispersion layer 177b may be changed in various ways. The second field dispersion layer 177b may be electrically connected to the source electrode 173. For example, the second field dispersion layer 177b may be connected to the intermediate source electrode 173b. The second field dispersion layer 177b may include the same material as the intermediate source electrode 173b and may be located in the same layer as the intermediate source electrode 173b. The second field dispersion layer 177b may be formed simultaneously with the intermediate source electrode 173b in the same process. The boundary between the second field dispersion layer 177b and the intermediate source electrode 173b may not be apparent, and the second field dispersion layer 177b may be formed integrally with the intermediate source electrode 173b. However, the present inventive concept is not limited thereto, and the second field dispersion layer 177b may be a separate element separated from the intermediate source electrode 173b. Additionally, the second field dispersion layer 177b may be located in a different layer from the intermediate source electrode 173b and may be formed in a different process.

The semiconductor device may further include a third field dispersion layer 177c on the third protective layer 160. The third field dispersion layer 177c may form a field dispersion layer together with the first field dispersion layer 177a and the second field dispersion layer 177b. The third field dispersion layer 177c may be located between the source electrode 173 and the drain electrode 175. The third field dispersion layer 177c may be overlapped with the gate electrode 155 in the third direction D3. The third field dispersion layer 177c may be overlapped with the first field dispersion layer 177a and the second field dispersion layer 177b in the third direction D3. The gate electrode 155, the first field dispersion layer 177a, and the second field dispersion layer 177b may be covered by the third field dispersion layer 177c. The third field dispersion layer 177c may have a larger width (e.g. in the second direction D2) than the second field dispersion layer 177b. The third field dispersion layer 177c may entirely cover the second field dispersion layer 177b. However, the present inventive concept is not limited thereto, and the width and positional relationship of the first field dispersion layer 177a, the second field dispersion layer 177b, and the third field dispersion layer 177c may be changed in various ways. The third field dispersion layer 177c may be electrically connected to the source electrode 173. For example, the third field dispersion layer 177c may be connected to the upper source electrode 173c. The third field dispersion layer 177c may include the same material as the upper source electrode 173c and may be located in the same layer as the upper source electrode 173c. The third field dispersion layer 177c may be formed simultaneously during the same process as the upper source electrode 173c. For example, a boundary between the third field dispersion layer 177c and the upper source electrode 173c may not be clear, and the third field dispersion layer 177c may be formed integrally with the upper source electrode 173c. However, the present disclosure is not limited thereto, and the third field dispersion layer 177c may be a separate element separated from the upper source electrode 173c. Additionally, the third field dispersion layer 177c may be located in a different layer from the upper source electrode 173c and may be formed in a different process.

In some embodiments, at least one of the first field dispersion layer 177a, the second field dispersion layer 177b, or the third field dispersion layer 177c may be omitted. For example, the semiconductor device may include the first field dispersion layer 177a and may not include the second field dispersion layer 177b or the third field dispersion layer 177c. Alternatively, the semiconductor device may include the second field dispersion layer 177b and not include the first field dispersion layer 177a or the third field dispersion layer 177c. Alternatively, the semiconductor device may include the third field dispersion layer 177c and not include the first field dispersion layer 177a or the second field dispersion layer 177b. Alternatively, the semiconductor device may not include the first field dispersion layer 177a, the second field dispersion layer 177b, and the third field dispersion layer 177c.

The semiconductor device includes a channel layer 132 on an outer region CSR of a substrate 110, a barrier layer 136 on the channel layer 132, and a crack propagation prevention structure CS that penetrates the channel layer 132 and the barrier layer 136 and is connected to (e.g. directly connected to) the substrate 110.

A channel layer 132 on an outer region CSR of a substrate 110 may be connected to a channel layer 132 on a transistor region TR of the substrate 110. The channel layer 132 on the outer region CSR of the substrate 110 may include the same material as the channel layer 132 on the transistor region TR of the substrate 110, and may be located in the same layer as the channel layer 132 on the transistor region TR of the substrate 110. The channel layer 132 on the outer region CSR of the substrate 110 may be formed simultaneously in the same process as the channel layer 132 on the transistor region TR of the substrate 110. The boundary between the channel layer 132 on the outer region CSR of the substrate 110 and the channel layer 132 on the transistor region TR of the substrate 110 may not be apparent, and the channel layer 132 on the outer region CSR of the substrate 110 may be formed integrally with the channel layer 132 on the transistor region TR of the substrate 110. However, the present disclosure is not limited thereto, and the channel layer 132 on the outer region CSR of the substrate 110 may be a separate element separated from the channel layer 132 on the transistor region TR of the substrate 110. Additionally, the channel layer 132 on the outer region CSR of the substrate 110 may be located in a different layer from the channel layer 132 on the transistor region TR of the substrate 110, and may be formed in a different process.

A barrier layer 136 on the outer region CSR of the substrate 110 may be connected to a barrier layer 136 on the transistor region TR of the substrate 110. The barrier layer 136 on the outer region CSR of the substrate 110 may include the same material as the barrier layer 136 on the transistor region TR of the substrate 110, and may be located in the same layer as the barrier layer 136 on the transistor region TR of the substrate 110. The barrier layer 136 on the outer region CSR of the substrate 110 may be formed simultaneously during the same process as the barrier layer 136 on the transistor region TR of the substrate 110. The boundary between the barrier layer 136 on the outer region CSR of the substrate 110 and the barrier layer 136 on the transistor region TR of the substrate 110 may not be apparent, and the barrier layer 136 on the outer region CSR of the substrate 110 may be formed integrally with the barrier layer 136 on the transistor region TR of the substrate 110. However, the present disclosure is not limited thereto, and the barrier layer 136 on the outer region CSR of the substrate 110 may be a separate element separated from the barrier layer 136 on the transistor region TR of the substrate 110. Additionally, the barrier layer 136 on the outer region CSR of the substrate 110 may be located in a different layer from the barrier layer 136 on the transistor region TR of the substrate 110, and may be formed in a different process.

The crack propagation prevention structure CS may penetrate through the channel layer 132 and the barrier layer 136 at a location on the outer region CSR of the substrate 110, thereby separating the channel layer 132 and the barrier layer 136 into a channel layer 132 and a barrier layer 136 located on a first side of the crack propagation prevention structure CS and a channel layer 132 and a barrier layer 136 located on an opposite, second side of the crack propagation prevention structure CS. Accordingly, the crack propagation prevention structure CS can prevent a crack occurring in the scribe lane regions SLR from propagating to the transistor region TR.

In some examples, the channel layer 132 and the barrier layer 136 on the first side of the crack propagation prevention structure CS may be the channel layer 132 and the barrier layer 136 on the left side of the crack propagation prevention structure CS when viewed in a cross-section (e.g., FIG. 5) cut perpendicularly to the first direction D1 in which the gate electrode 155 extends, and may be, for example, the channel layer 132 and the barrier layer 136 between the source electrode 173 and the crack propagation prevention structure CS. The channel layer 132 and the barrier layer 136 located on the second side of the crack propagation prevention structure CS may be the channel layer 132 and the barrier layer 136 located on the right side of the crack propagation prevention structure CS when viewed in a cross-section (e.g., FIG. 5) cut perpendicularly to the first direction D1 in which the gate electrode 155 extends, and may be, for example, the channel layer 132 and the barrier layer 136 between the scribe lane regions SLR and the crack propagation prevention structure CS.

A portion of the upper surface US_110 of the substrate 110, the channel layer 132, and the barrier layer 136 on the outer region CSR of the substrate 110 may include an ion implant region IP. Additionally, when the seed layer 115 and the buffer layer 120 are located between the substrate 110 and the channel layer 132, the seed layer 115 and the buffer layer 120 may further include an ion implant region IP.

For example, the ion implant region IP may include a first ion implant layer IP_110 in a portion of the upper surface US_110 of the substrate 110, a second ion implant layer IP_115 in the seed layer 115, a third ion implant layer IP_120 in the buffer layer 120, a fourth ion implant layer IP_132 in the channel layer 132, and a fifth ion implant layer IP_136 in the barrier layer 136.

For example, the ion implant region IP may be formed by injecting a material such as Ar using the ion implantation (IIP) method while a seed layer 115, a buffer layer 120, a channel layer 132, and a barrier layer 136 are formed on a substrate 110. In some examples, a material such as Ar may penetrate into a portion of the upper surface US_110 of the substrate 110, so that an ion implant region IP may be formed in a portion of the upper surface US_110 of the substrate 110.

The ion implant region IP may be located on the outer region CSR of the substrate 110 and may extend along the outer region CSR. For example, the ion implant region IP may surround a transistor region TR.

On a plane (e.g., FIG. 4), the ion implant regions IP on a first side and an opposite, second side of the transistor region TR in the second direction D2 may extend in the first direction D1 parallel to the source electrode 173, the gate electrode 155, and the drain electrode 175, and the ion implant regions IP on the first side and the second side of the transistor region TR in the first direction D1 may extend in the second direction D2 passing through the spaced-apart source electrode 173, the gate electrode 155, and the drain electrode 175.

The crack propagation prevention structure CS may penetrate through the ion implant region IP located on the outer region CSR of the substrate 110, thereby dividing the ion implant region IP into an ion implant region IP located on the first side of the crack propagation prevention structure CS and an ion implant region IP located on the second side of the crack propagation prevention structure CS. In such examples, the ion implant region IP located on the first side of the crack propagation prevention structure CS may be an ion implant region IP located on the left side of the crack propagation prevention structure CS when viewed in a cross-section (e.g., FIG. 5) cut perpendicularly to the first direction D1 in which the gate electrode 155 extends, and may be, for example, an ion implant region IP located between the source electrode 173 and the crack propagation prevention structure CS. The ion implant region IP located on the second side of the crack propagation prevention structure CS may be an ion implant region IP located on the right side of the crack propagation prevention structure CS when viewed in a cross-section (e.g., FIG. 5) cut perpendicularly to the first direction D1 in which the gate electrode 155 extends, and may be, for example, an ion implant region IP located between the scribe lane regions SLR and the crack propagation prevention structure CS.

The crack propagation prevention structure CS may be located in the outer region CSR of the substrate 110 and may extend along the outer region CSR. For example, a crack propagation barrier structure CS may surround a transistor region TR.

On a plane (e.g., FIG. 4), the crack propagation prevention structure CS on a first side and an opposite, second side of the transistor region TR in the second direction D2 may extend in the first direction D1 parallel to the source electrode 173, the gate electrode 155, and the drain electrode 175, and the crack propagation prevention structure CS on the first side and the second side of the transistor region TR in the first direction D1 may extend in the second direction D2 passing through the spaced-apart source electrode 173, the gate electrode 155, and the drain electrode 175. In some examples, the crack propagation prevention structure CS located in the outer region CSR is arranged to be spaced apart from the source electrode 173, the gate electrode 155, and the drain electrode 175 located in the transistor region TR, and the crack propagation prevention structure CS may surround the source electrode 173, the gate electrode 155, and the drain electrode 175 located in the transistor region TR.

A crack propagation prevention structure CS may be located on a first side of the source electrode 173. For example, in a transistor region TR, a source electrode 173, a gate electrode 155, and a drain electrode 175 may be alternately arranged in a second direction D2, and the source electrode 173 may be arranged at an end in the second direction D2. For example, a source electrode 173, a gate electrode 155, a drain electrode 175, a gate electrode 155, a source electrode 173, a gate electrode 155, a drain electrode 175, a gate electrode 155, a source electrode 173 may be arranged in the second direction D2. In such examples, the crack propagation prevention structure CS is located in the outer region CSR surrounding the transistor region TR and the crack propagation prevention structure CS may be located on a first side of the source electrode 173 in the second direction D2, and the crack propagation prevention structure CS may extend in the first direction D1 along the source electrode 173.

The crack propagation prevention structure CS is located apart from the source electrode 173 and may be connected to the source electrode 173. The crack propagation prevention structure CS may be electrically connected to the source electrode 173. For example, the crack propagation prevention structure CS may be connected to the upper source electrode 173c of the source electrode 173 through the third metal liner 193 described below.

Additionally, the crack propagation prevention structure CS may be connected to the field dispersion layer 177. The crack propagation prevention structure CS may be electrically connected to the field dispersion layer 177. For example, the crack propagation prevention structure CS may be connected to the upper source electrode 173c of the source electrode 173 through the third metal liner 193, and as the upper source electrode 173c is connected to the third field dispersion layer 177c of the field dispersion layer 177, the third metal liner 193 of the crack propagation prevention structure CS and the third field dispersion layer 177c of the field dispersion layer 177 may be connected.

The crack propagation prevention structure CS may penetrate through the channel layer 132 and the barrier layer 136 located on the outer region CSR of the substrate 110 and be connected to the upper surface US_110 of the substrate 110. The crack propagation prevention structure CS may be electrically connected to the upper surface US_110 of the substrate 110. For example, the crack propagation prevention structure CS may be connected to the upper surface US_110 of the substrate 110 through the first metal liner 191 described below.

Accordingly, as the crack propagation prevention structure CS is electrically connected to the source electrode 173 and the substrate 110, the source electrode 173 may be connected to the substrate 110 as an ohmic metal through the crack propagation prevention structure CS. For example, by using the crack propagation prevention structure CS as a substrate contact, an epitaxial layer such as a buffer layer 120 or a channel layer 132 can be floated so that charges that may accumulate can escape to the source electrode 173 through the crack propagation prevention structure CS.

The crack propagation prevention structure CS covers side surfaces SW_132 of a channel layer 132 on an outer region CSR of a substrate 110 and includes a first metal liner 191 on an upper surface US_110 of the substrate 110.

The first metal liner 191 can cover side surfaces SW_132 of the channel layer 132 located on the outer region CSR of the substrate 110 and the upper surface US_110 of the substrate 110. The first metal liner 191 may be formed conformally. For example, the thickness of the first metal liner 191 on the upper surface US_110 of the substrate 110 may be similar to the thickness of the first metal liner 191 on side surfaces SW_132 of the channel layer 132.

When a buffer layer 120 and a seed layer 115 are further located between the substrate 110 and the channel layer 132, the first metal liner 191 may also be on both side surfaces of the buffer layer 120 and the seed layer 115. In addition, when a portion of the upper surface US_110 of the substrate 110, the barrier layer 136, the channel layer 132, the seed layer 115, and the buffer layer 120 located on the outer region CSR of the substrate 110 include an ion implant region IP, the first metal liner 191 may be located on side surfaces of the first to fifth ion implant layers IP_110, IP_115, IP_120, IP_132, and IP_136.

The first metal liner 191 may be in contact with the upper surface US_110 of the substrate 110 and may be electrically connected to the substrate 110. Accordingly, the crack propagation prevention structure CS may be electrically connected to the source electrode 173 and the substrate 110 and used as a substrate contact.

In addition, as the first metal liner 191 covers the upper surface US_110 of the substrate 110 and side surfaces SW_132 of the channel layer 132, the upper surface US_110 of the substrate 110 and side surfaces SW_132 of the channel layer 132 are covered with metal, thereby obtaining a moisture absorption prevention effect.

For example, the first metal liner 191 may include the same material as the lower source electrode 173a and may be located in the same layer as the lower source electrode 173a. The first metal liner 191 may be formed simultaneously with the lower source electrode 173a in the same process. The first metal liner 191 and the lower source electrode 173a may be spaced apart. However, the present inventive concept is not limited thereto, and the first metal liner 191 may be located in a different layer from the lower source electrode 173a and may be formed in a different process.

The crack propagation prevention structure CS may further include a first insulating liner 151 on the first metal liner 191. The first insulating liner 151 may cover the upper surface of the first metal liner 191 and can cover the side surface of the first protective layer 140. The lower surface of the first insulating liner 151 may be in contact with the upper surface of the first metal liner 191 and the upper surface and side surface of the first protective layer 140. The upper surface of the first insulating liner 151 may be in contact with the lower surface of the second metal liner 192 described later. For example, the first insulating liner 151 may be located between the first metal liner 191 and the second metal liner 192.

The first insulating liner 151 may be spaced from the upper surface US_110 of the substrate 110 and side surfaces SW_132 of the channel layer 132 by the first metal liner 191. The first insulating liner 151 may space apart the first metal liner 191 and the second metal liner 192.

The first insulating liner 151 can be formed conformally. For example, the thickness of the first insulating liner 151 on the upper surface US_110 of the substrate 110 may be similar to the thickness of the first insulating liner 151 on side surfaces SW_132 of the channel layer 132.

For example, the first insulating liner 151 may include the same material as the second protective layer 150 and may be located in the same layer as the second protective layer 150. The first insulating liner 151 may be formed simultaneously with the second protective layer 150 in the same process. The boundary between the first insulating liner 151 and the second protective layer 150 may not be apparent, and the first insulating liner 151 may be formed integrally with the second protective layer 150. However, the present inventive concept is not limited thereto, and the first insulating liner 151 may be a separate element separated from the second protective layer 150. Additionally, the first insulating liner 151 may be located in a different layer from the second protective layer 150 and may be formed in a different process.

The crack propagation prevention structure CS may further include a second metal liner 192 on the first insulating liner 151.

The second metal liner 192 may cover the first insulating liner 151. As the second metal liner 192 covers the first insulating liner 151, an anti-moisture absorption effect may be obtained as the first insulating liner 151 is covered with metal. The second metal liner 192 can be formed conformally. For example, the thickness of the second metal liner 192 on the upper surface US_110 of the substrate 110 may be similar to the thickness of the second metal liner 192 on side surfaces SW_132 of the channel layer 132.

The second metal liner 192 may not be in contact with the upper surface US_110 of the substrate 110 due to the first insulating liner 151. The crack propagation prevention structure CS may further include a first via V_192 penetrating the first insulating liner 151 and connecting the first metal liner 191 and the second metal liner 192. The second metal liner 192 may be electrically connected to the first metal liner 191 by the first via V_192, and the second metal liner 192 can be electrically connected to the upper surface US_110 of the substrate 110 through the first metal liner 191. In addition, since the crack propagation prevention structure CS further includes a first via V_192 penetrating the first insulating liner 151, a stress release effect can be obtained.

For example, the second metal liner 192 may include the same material as the intermediate source electrode 173b and may be located in the same layer as the intermediate source electrode 173b. The second metal liner 192 may be formed simultaneously with the intermediate source electrode 173b in the same process. The second metal liner 192 and the intermediate source electrode 173b may be spaced apart. However, the present inventive concept is not limited thereto, and the second metal liner 192 may be located in a different layer from the intermediate source electrode 173b and may be formed in a different process.

The crack propagation prevention structure CS may further include a second insulating liner 161 on the second metal liner 192. The second insulating liner 161 can cover the upper surface of the second metal liner 192. The lower surface of the second insulating liner 161 may be in contact with the upper surface of the second metal liner 192 and the upper surface of the first insulating liner 151. The upper surface of the second insulating liner 161 may be in contact with the lower surface of the third metal liner 193 described later. For example, the second insulating liner 161 may be located between the second metal liner 192 and the third metal liner 193. The second insulating liner 161 may space apart the second metal liner 192 and the third metal liner 193.

The second insulating liner 161 can be formed conformally. For example, the thickness of the second insulating liner 161 on the upper surface US_110 of the substrate 110 may be similar to the thickness of the second insulating liner 161 on side surfaces SW_132 of the channel layer 132.

For example, the second insulating liner 161 may include the same material as the third protective layer 160 and may be located in the same layer as the third protective layer 160. The second insulating liner 161 may be formed simultaneously with the third protective layer 160 in the same process. The boundary between the second insulating liner 161 and the third protective layer 160 may not be apparent, and the second insulating liner 161 may be formed integrally with the third protective layer 160. However, the present inventive concept is not limited thereto, and the second insulating liner 161 may be a separate element separated from the third protective layer 160. Additionally, the second insulating liner 161 may be located in a different layer from the third protective layer 160 and may be formed in a different process.

The crack propagation prevention structure CS may further include a third metal liner 193 on the second insulating liner 161.

The third metal liner 193 may cover the second insulating liner 161. As the third metal liner 193 covers the second insulating liner 161, an anti-moisture absorption effect can be obtained as the second insulating liner 161 is covered with metal. The third metal liner 193 may be formed conformally. For example, the thickness of the third metal liner 193 on the upper surface US_110 of the substrate 110 may be similar to the thickness of the third metal liner 193 on side surfaces SW_132 of the channel layer 132.

The third metal liner 193 may not be in contact with the upper surface US_110 of the substrate 110 due to the second insulating liner 161. The crack propagation prevention structure CS may further include a second via V_193 penetrating the second insulating liner 161 and connecting the second metal liner 192 and the third metal liner 193. The third metal liner 193 may be electrically connected to the second metal liner 192 by the second via V_193, and the third metal liner 193 may be electrically connected to the upper surface US_110 of the substrate 110 through the second metal liner 192 and the first metal liner 191. In addition, since the crack propagation prevention structure CS further includes a second via V_193 penetrating the second insulating liner 161, a stress release effect can be obtained.

Additionally, the third metal liner 193 may be electrically connected to the source electrode 173. For example, the third metal liner 193 may be connected to the upper source electrode 173c. Accordingly, the crack propagation prevention structure CS may be electrically connected to the source electrode 173. The third metal liner 193 may include the same material as the upper source electrode 173c and may be located in the same layer as the upper source electrode 173c. The third metal liner 193 may be formed simultaneously with the upper source electrode 173c in the same process. The boundary between the third metal liner 193 and the upper source electrode 173c may not be apparent, and the third metal liner 193 may be formed integrally with the upper source electrode 173c. However, the present inventive concept is not limited thereto, and the third metal liner 193 may be located in a different layer from the upper source electrode 173c and may be formed in a different process.

In addition, as described above, when the third field dispersion layer 177c is electrically connected to the source electrode 173, the third metal liner 193 is also electrically connected to the source electrode 173, and thus, the third metal liner 193 may be electrically connected to the third field dispersion layer 177c. Accordingly, the crack propagation prevention structure CS may be electrically connected to the field dispersion layer 177. The third metal liner 193 may include the same material as the third field dispersion layer 177c and may be located in the same layer as the third field dispersion layer 177c. The third metal liner 193 may be formed simultaneously with the third field dispersion layer 177c in the same process. The boundary between the third metal liner 193 and the third field dispersion layer 177c may not be apparent, and the third metal liner 193 may be formed integrally with the third field dispersion layer 177c. However, the present inventive concept is not limited thereto, and the third metal liner 193 may be located in a different layer from the third field dispersion layer 177c and may be formed in a different process.

In some embodiments, at least one of the first metal liner 191, the second metal liner 192, or the third metal liner 193 may be omitted. For example, the crack propagation prevention structure CS may include a first metal liner 191 and may not include a second metal liner 192 or a third metal liner 193. In this case, the first metal liner 191 may be in contact with the upper surface US_110 of the substrate 110 and connected to the lower source electrode 173a of the source electrode 173. Alternatively, the crack propagation prevention structure CS may include a second metal liner 192 and may not include a first metal liner 191 or a third metal liner 193. In this case, the second metal liner 192 is connected to the upper surface US_110 of the substrate 110 through the first via V_192 and may be connected to the intermediate source electrode 173b of the source electrode 173. Alternatively, the crack propagation prevention structure CS may include a third metal liner 193 and may not include the first metal liner 191 or the second metal liner 192. In this case, the third metal liner 193 is connected to the upper surface US_110 of the substrate 110 through the second via V_193 and may be connected to the upper source electrode 173c of the source electrode 173.

The first metal liner 191 may have a first lower extension portion 191_B, first upper extension portions 191_U, and first side wall portions 191_SW.

The first lower extension portion 191_B of the first metal liner 191 is located on the upper surface US_110 of the substrate 110. The first lower extension portion 191_B may be in contact with the upper surface US_110 of the substrate 110. The first lower extension portion 191_B may extend horizontally to the upper surface US_110 of the substrate 110.

The first upper extension portions 191_U of the first metal liner 191 are respectively located on the upper surfaces of the channel layers 132 on opposing sides of the crack propagation prevention structure CS. The first upper extension portions 191_U may be in contact with the upper surface of the channel layer 132. When the channel layer 132 on the outer region CSR of the substrate 110 includes an ion implant region IP, the first upper extension portions 191_U may be in contact with the upper surface of the fourth ion implant layer IP_132. The first upper extension portions 191_U may extend horizontally to the upper surface of the channel layer 132.

The first side wall portions 191_SW of the first metal liner 191 are located on side surfaces SW_132 of the channel layer 132 located on opposing sides of the crack propagation prevention structure CS. The first side wall portions 191_SW may be in contact with the side surfaces SW_132 of the channel layer 132. When the channel layer 132 on the outer region CSR of the substrate 110 includes an ion implant region IP, the first side wall portions 191_SW may be in contact with the side surfaces of the fourth ion implant layer IP_132.

The first side wall portions 191_SW may connect between the first lower extension portion (191_B) and the first upper extension portions 191_U.

Since the first lower extension portion 191_B is located on the upper surface US_110 of the substrate 110 and the first upper extension portions 191_U are located on the upper surface of the channel layer 132, the level of the first upper extension portions 191_U in the third direction D3 with respect to the upper surface US_110 of the substrate 110 may be higher than the level of the first lower extension portion 191_B in the third direction D3.

In a cross-section cut perpendicular to the first direction D1 (for example, FIG. 6), an angle θ_191 formed by the first lower extension portion 191_B of the first metal liner 191 and the first side wall portion 191_SW may be greater than about 90°, greater than or equal to about 95°, for example, greater than or equal to about 100°, greater than or equal to about 105°, greater than or equal to about 110°, greater than or equal to about 115°, greater than or equal to about 120°, or greater than or equal to about 125°, and may be less than or equal to about 130°, for example, less than or equal to about 125°, less than or equal to about 120°, less than or equal to about 115°, less than or equal to about 110°, less than or equal to about 105°, or less than or equal to about 100°, and may be about 95° to about 130°. When the angle θ_191 formed by the first lower extension portion 191_B and the first side wall portion 191_SW of the first metal liner 191 is within the range, cracks can be effectively prevented from being transmitted to the semiconductor device.

The second metal liner 192 may have a second lower extension portion 192_B, second upper extension portions 192_U, and second side wall portions 192_SW.

The second lower extension portion 192_B of the second metal liner 192 is located on the first lower extension portion 191_B. A first insulating liner 151 may be located between the second lower extension portion 192_B and the first lower extension portion 191_B. The second lower extension portion 192_B and the first lower extension portion 191_B may be connected by a first via V_192. For example, the first via V_192 may be located between the second lower extension portion 192_B and the first lower extension portion 191_B. The second lower extension portion 192_B may extend horizontally to the upper surface US_110 of the substrate 110.

The second upper extension portions 192_U of the second metal liner 192 are located on the first upper extension portions 191_U. A first insulating liner 151 may be located between the second extension portions 192_U and the first upper extension portions 191_U. The second upper extension portions 192_U may extend horizontally to the upper surface of the channel layer 132.

The second side wall portions 192_SW of the second metal liner 192 are located on the first side wall portions 191_SW. A first insulating liner 151 may be located between the second side wall portions 192_SW and the first side wall portions 191_SW. The second side wall portions 192_SW can connect between the second lower extension portion 192_B and the second upper extension portions 192_U.

Since the second lower extension portion 192_B is on the upper surface US_110 of the substrate 110 and the second upper extension portions 192_U are on the upper surface of the channel layer 132, the level of the second upper extension portions 192_U in the third direction D3 with respect to the upper surface US_110 of the substrate 110 may be higher than the level of the second lower extension portion 192_B in the third direction D3.

In a cross-section cut perpendicular to the first direction D1 (for example, FIG. 6), the angle formed by the second lower extension portion 192_B and the second side wall portion 192_SW of the second metal liner 192 may be greater than about 90°, greater than or equal to about 95°, for example, greater than or equal to about 100°, greater than or equal to about 105°, greater than or equal to about 110°, greater than or equal to about 115°, greater than or equal to about 120°, or greater than or equal to about 125°, and may be less than or equal to about 130°, for example, less than or equal to about 125°, less than or equal to about 120°, less than or equal to about 115°, less than or equal to about 110°, less than or equal to about 105°, or less than or equal to about 100°, and may be about 95° to about 130°. When the angle formed by the second lower extension portion 192_B and the second side wall portion 192_SW of the second metal liner 192 is within the above range, cracks can be effectively prevented from being transmitted to the semiconductor device.

The third metal liner 193 may have a third lower extension portion 193_B, third upper extension portions 193_U, and third side wall portions 193_SW.

The third lower extension portion 193_B of the third metal liner 193 is located on the second lower extension portion 192_B. A second insulating liner 161 may be located between the third lower extension portion 193_B and the second lower extension portion 192_B. The third lower extension portion 193_B and the second lower extension portion 192_B may be connected by a second via V_193. For example, the second via V_193 may be located between the third lower extension portion 193_B and the second lower extension portion 192_B. The third lower extension portion 193_B may extend horizontally to the upper surface US_110 of the substrate 110.

The third upper extension portions 193_U of the third metal liner 193 are located on the second upper extension portions 192_U. A second insulating liner 161 may be located between the third upper extension portions 193_U and the second upper extension portions 192_U. The third upper extension portions 193_U may extend horizontally to the upper surface of the channel layer 132.

The third side wall portions 193_SW of the third metal liner are located on the second side wall portions 192_SW. A second insulating liner 161 may be located between the third side wall portions 193_SW and the second side wall portions 192_SW. The third side wall portions 193_SW can connect between the third lower extension portion 193_B and the third upper extension portions 193_U.

Since the third lower extension portion 193_B is located on the upper surface US_110 of the substrate 110 and the third upper extension portions 193_U are located on the upper surface of the channel layer 132, the level of the third upper extension portions 193_U in the third direction D3 with respect to the upper surface US_110 of the substrate 110 may be higher than the level of the third lower extension portion 193_B in the third direction D3.

In a cross-section cut perpendicular to the first direction D1 (for example, FIG. 6), the angle formed by the third lower extension portion 193_B and the third side wall portion 193_SW of the third metal liner 193 may be greater than about 90°, greater than or equal to about 95°, for example, greater than or equal to about 100°, greater than or equal to about 105°, greater than or equal to about 110°, greater than or equal to about 115°, greater than or equal to about 120°, or greater than or equal to about 125°, and may be less than or equal to about 130°, for example, less than or equal to about 125°, less than or equal to about 120°, less than or equal to about 115°, less than or equal to about 110°, less than or equal to about 105°, or less than or equal to about 100°, and may be about 95° to about 130°. When the angle formed by the third lower extension portion 193_B and the third side wall portion 193_SW of the third metal liner 193 is within the above range, cracks can be effectively prevented from being transmitted to the semiconductor device.

In a cross-section (e.g., FIG. 6) cut perpendicular to the first direction D1, the width W_192_B of the second lower extension portion 192_B in the second direction D2 may be smaller than the width W_191_B of the first lower extension portion 191_B in the second direction D2. The width W_193_B of the third lower extension portion 193_B in the second direction D2 may be smaller than the width W_192_B of the second lower extension portion 192_B in the second direction D2.

Additionally, in a cross-section cut perpendicular to the first direction D1 (e.g., FIG. 6), the width W_192_U of one or more (e.g. each) of the second upper extension portions 192_U in the second direction D2 may be larger than the width W_191_U of one or more (e.g. each) of the first upper extension portions 191_U in the second direction D2. The width W_193_U of one or more (e.g. each) of the third upper extension portions 193_U in the second direction D2 may be larger than the width W_192_U of one or more (e.g. each) of the second upper extension portions 192_U in the second direction D2. Here, the width W_191_U of the first upper extension portion 191_U in the second direction D2, the width W_192_U of the second upper extension portion 192_U in the second direction D2, and the width W_193_U of the third upper extension portion 193_U in the second direction D2 may be used as a starting point based on a reference line that passes through the point where the first side wall portion (191_SW) and the first upper extension portion 191_U meet and extends in the third direction D3. For example, in a cross-section cut perpendicular to the first direction D1 (e.g., FIG. 6), the width W_191_U of the first upper extension portion 191_U in the second direction D2 may be the shortest distance from the reference line to one end of the first upper extension portion 191_U in the second direction D2, the width W_192_U of the second upper extension portion 192_U in the second direction D2 may be the shortest distance from the reference line to one end of the second upper extension portion 192_U in the second direction D2, and the width W_193_U of the third upper extension portion 193_U in the second direction D2 may be the shortest distance from the reference line to one end of the third upper extension portion 193_U in the second direction D2.

Additionally, in a cross-section cut perpendicular to the first direction D1 (e.g., FIG. 6), the width of the first via V_192 in the second direction D2 may be larger than the width of the second via V_193 in the second direction D2.

Accordingly, the crack propagation prevention structure CS can have a first recess ET1 described below between the third lower extension portion 193_B and the third side wall portion 193_SW, and the angle between the third lower extension portion 193_B and the third side wall portion 193_SW can be adjusted, and the generation of by-products due to etching during the formation of the crack propagation prevention structure CS can be minimized.

As the level of the first to third upper extension portions 191_U and 192_U, 193_U in the third direction D3 is higher than the level of the first to third lower extension portions 191_B and 192_B, 193_B in the third direction D3 based on the upper surface US_110 of the substrate 110, in a cross-section cut perpendicular to the first direction D1 (for example, FIG. 6), the crack propagation prevention structure CS may have a convex shape toward the substrate 110.

In addition, in a cross-section cut perpendicular to the first direction D1 (for example, FIG. 6), since the angle formed by each of the first to third lower extension portions 191_B and 192_B, 193_B and the first to third side wall portions 191_SW, 192_SW, and 193_SW is greater than about 90°, the crack propagation prevention structure CS may have a first recess ET1 between the third lower extension portion 193_B and the third side wall portion 193_SW. The first recess ET1 may extend along the crack propagation prevention structure CS. In addition, since the crack propagation prevention structure CS has the first recess ET1 between the third lower extension portion 193_B and the third side wall portions 193_SW, in a cross-section cut perpendicular to the first direction D1 (for example, FIG. 6), the crack propagation prevention structure CS may have a "U" or "V" shape. Accordingly, the crack propagation prevention structure CS can effectively prevent a crack occurring in the scribe lane regions SLR from propagating to the transistor region TR.

The semiconductor device may further include a metal silicide layer SC located between the substrate 110 and the crack propagation prevention structure CS. For example, the metal silicide layer SC may be located between the upper surface US_110 of the substrate 110 and the first lower extension portion 191_B of the first metal liner 191.

As the metal silicide layer SC is located between the substrate 110 and the crack propagation prevention structure CS, the contact resistance between the substrate 110 and the crack propagation prevention structure CS can be improved when in substrate contact.

In some examples, the first metal liner 191 may include a metal capable of forming a metal silicide with Si of the substrate 110. For example, the first metal liner 191 may include titanium (Ti), tantalum (Ta), tungsten (W), nickel (Ni), cobalt (Co), molybdenum (Mo), or a combination thereof.

Accordingly, the metal silicide layer SC may include titanium silicide, tantalum silicide, tungsten silicide, nickel silicide, cobalt silicide, molybdenum silicide, or a combination thereof.

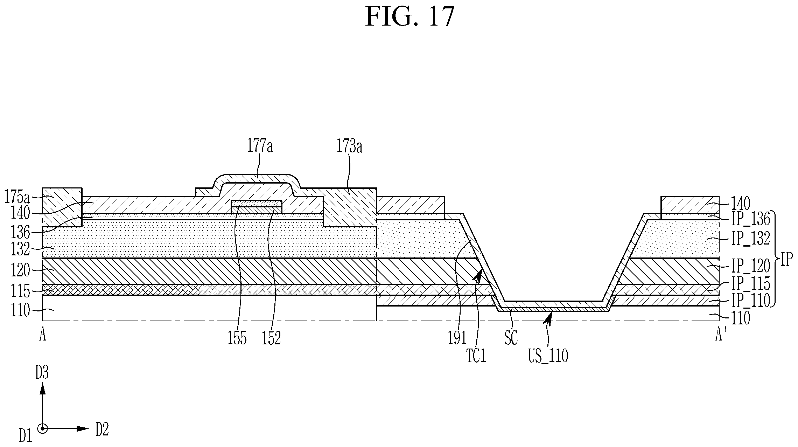

For example, the metal silicide layer SC may be formed by forming a first trench TC1 that penetrates the channel layer 132 on the outer region CSR of the substrate 110 to expose the upper surface US_110 of the substrate 110, as described later in FIG. 17, and then depositing a first metal liner 191 that covers the upper surface US_110 of the substrate 110 and side surfaces SW_132 of the channel layer 132 exposed through the first trench TC1, and then heat-treating at a temperature of about 550 °C to about 700 °C.

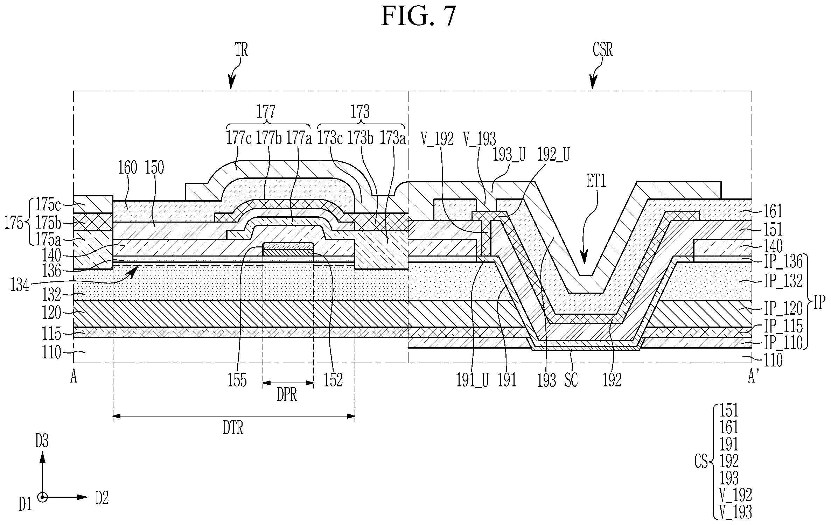

FIG. 7 is a cross-sectional view taken along line A-A' of FIG. 4, showing another embodiment.

Since the embodiment shown in FIG. 7 has many of the same parts as the embodiments shown in FIGS. 5 and 6, descriptions thereof that may be redundant may be omitted and the differences will be mainly explained. Additionally, the same reference numerals are used for the same components as those in the previous embodiment.

Referring to FIGS. 5 and 6, the first via V_192 is located between the second lower extension portion 192_B and the first lower extension portion 191_B, and the second via V_193 is located between the third lower extension portion 193_B and the second lower extension portion 192_B.

Referring to FIG. 7, the first via V_192 is located between the second upper extension portion 192_U and the first upper extension portion 191_U, and the second via V_193 is located between the third upper extension portion 193_U and the second upper extension portion 192_U. The first via V_192 and the second via V_193 may be located between the first recess ET1 and the transistor region TR.

For example, when the surfaces of the first insulating liner 151 and the second insulating liner 161 are planarized using a process such as etch back or CMP (Chemical Mechanical Polishing) before forming the first insulating liner 151 and forming the second metal liner 192, or before forming the second insulating liner 161 and forming the third metal liner 193, a first via V_192 may be formed in the first insulating liner 151 located between the second upper extension portion 192_U and the first upper extension portion 191_U, and a second via V_193 may be formed in the second insulating liner 161 located between the third upper extension portion 193_U and the second upper extension portion 192_U.

Additionally, in a cross-section cut perpendicular to the first direction D1 (for example, FIG. 7), the width of the first via V_192 in the second direction D2 may be smaller than the width of the second via V_193 in the second direction D2, but is not limited thereto.

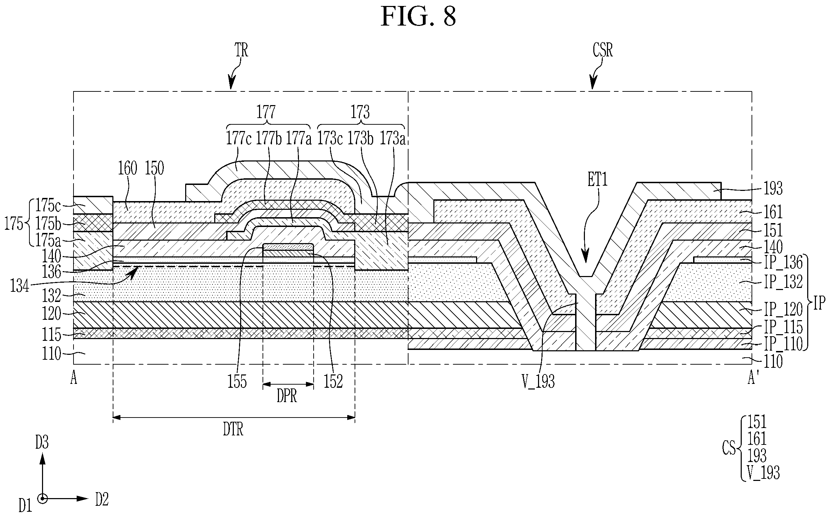

FIG. 8 is a cross-sectional view taken along line A-A' of FIG. 4, showing another embodiment.

Since the embodiment shown in FIG. 8 has many of the same parts as the embodiments shown in FIGS. 5 and 6, descriptions that may be redundant may be omitted and the differences will be mainly explained. Additionally, the same reference numerals are used for the same components as those in the previous embodiment.

Referring to FIGS. 5 and 6, the crack propagation prevention structure CS includes a first metal liner 191, a second metal liner 192, and a third metal liner 193.

Referring to FIG. 8, the crack propagation prevention structure CS includes a third metal liner 193 and does not include a first metal liner 191 and a second metal liner 192.

The first insulating liner 151 may cover side surfaces SW_132 of the channel layer 132 located on the outer region CSR of the substrate 110 and the upper surface US_110 of the substrate 110. The second insulating liner 161 may cover the first insulating liner 151.

The third metal liner 193 may cover the second insulating liner 161. The third metal liner 193 is connected to the upper surface US_110 of the substrate 110 through a second via V_193 and may be connected to the upper source electrode 173c of the source electrode 173.

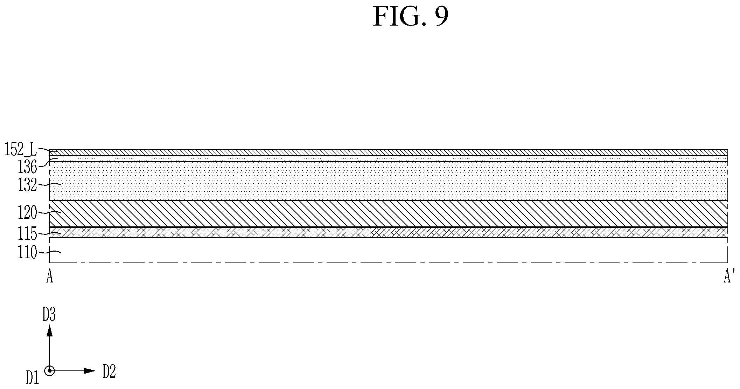

Next, a method for manufacturing a semiconductor device according to one embodiment will be described with reference to FIGS. 9 to 20. In addition, reference may be made to FIGS. 4 to 6 described above.

FIGS. 9 to 20 are cross-sectional views showing a method manufacturing a semiconductor device in process order.

Referring to FIG. 9, a seed layer 115, a buffer layer 120, and a channel layer 132 are sequentially formed on a substrate 110.

The seed layer 115, buffer layer 120, and channel layer 132 may be formed sequentially using an epitaxial growth method. A seed layer 115 may be first formed on a substrate 110, and a buffer layer 120 may be formed on the seed layer 115. The buffer layer 120 may include a superlattice layer and a high-resistance layer. A channel layer 132 may be formed on the buffer layer 120.

The seed layer 115, buffer layer 120, and channel layer 132 may be made of the same semiconductor material. However, considering the role of each layer and the performance required for the semiconductor device, the material composition ratio of each layer may be different.

For example, the substrate 110 includes Si, the seed layer 115 includes AIN, and the superlattice layer of the buffer layer 120 has a structure in which a layer made of AlGaN and a layer made of GaN are repeatedly stacked. The high-resistance layer of the buffer layer 120 may include GaN, and the channel layer 132 may include GaN. The channel layer 132 may be doped with impurities or may be undoped.

As the lattice structure of Si and GaN are different, it may not be easy to grow the channel layer 132 made of GaN directly on the substrate 110 made of Si. Accordingly, by first forming the seed layer 115 or the buffer layer 120 on the substrate 110 and then forming the channel layer 132, the lattice structure of the channel layer 132 can be stably formed.

Next, a barrier layer 136 and a gate semiconductor material layer 152_L may be sequentially formed on the channel layer 132.

The barrier layer 136 and the gate semiconductor material layer 152_L may be formed sequentially using an epitaxial growth method. The barrier layer 136 and the gate semiconductor material layer 152_L may be made of the same semiconductor material as the seed layer 115, the buffer layer 120, and the channel layer 132. However, the material composition ratio of each layer may be different depending on the role of each layer and the performance required for the semiconductor device.

As an example, the barrier layer 136 may include AlGaN. The barrier layer 136 may be doped with impurities or may be undoped. The gate semiconductor material layer 152_L may include GaN and may be doped with impurities. The gate semiconductor material layer 152_L may be doped with a p-type impurity, for example, magnesium (Mg).

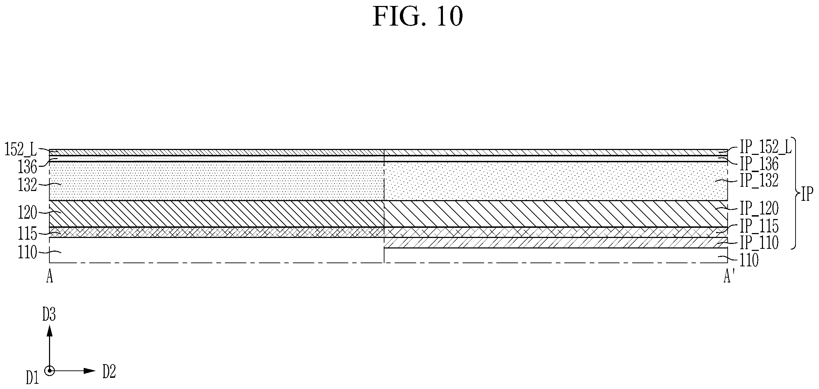

Referring to FIG. 10, an ion implant region IP may be formed in a seed layer 115, a buffer layer 120, a channel layer 132, a barrier layer 136, and a gate semiconductor material layer 152_L located on a portion of a substrate 110.

For example, the ion implant region IP may be formed by injecting a material such as Ar using the ion implantation (IIP) method while a seed layer 115, a buffer layer 120, a channel layer 132, a barrier layer 136, and a gate semiconductor material layer 152_L are formed on a substrate 110. In some examples, a material such as Ar may penetrate into a portion of the upper surface US_110 of the substrate 110, so that an ion implant region IP may be formed in a portion of the upper surface US_110 of the substrate 110.

Accordingly, a first ion implant layer IP_110 in a portion of the upper surface US_110 of the substrate 110, a second ion implant layer IP_115 in the seed layer 115, a third ion implant layer IP_120 in the buffer layer 120, a fourth ion implant layer IP_132 in the channel layer 132, a fifth ion implant layer IP_136 in the barrier layer 136, and a sixth ion implant layer IP_152_L in the gate semiconductor material layer 152_L may be formed.

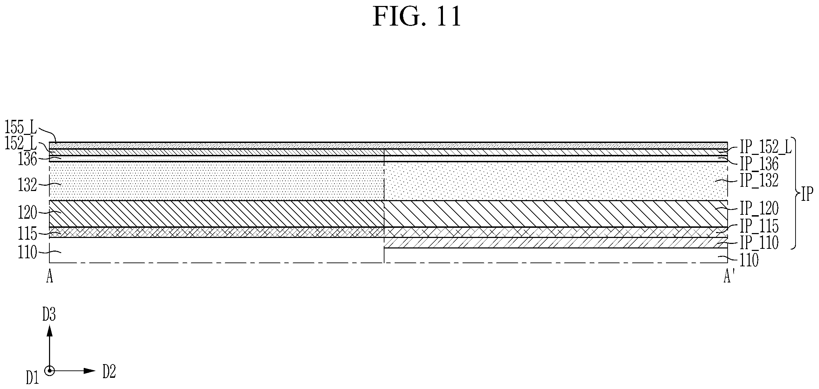

Referring to FIG. 11, a gate electrode material layer 155_L can be formed on the gate semiconductor material layer 152_L and the sixth ion implant layer IP_152_L.

As an example, the gate electrode material layer 155_L may be formed using a deposition process. For example, the gate electrode material layer 155_L may be formed using electron beam evaporation (E-beam evaporation), sputtering, physical vapor deposition (PVD), thermal chemical vapor deposition (thermal CVD), and low pressure chemical vapor deposition (LP-CVD), plasma-enhanced chemical vapor deposition (PE-CVD), or atomic layer deposition (ALD), etc., but is not limited thereto.

Referring to FIG. 12, the gate electrode material layer 155_L and the gate semiconductor material layer 152_L are etched to form the gate electrode 155 and the gate semiconductor layer 152. In some examples, the sixth ion implant layer IP_152_L may be removed.

For example, a gate electrode material layer 155_L and a gate semiconductor material layer 152_L may be patterned using a hard mask. Etching of the gate electrode material layer 155_L and the gate semiconductor material layer 152_L may be performed by dry etching using an etching gas. The etching gas may include a fluoride gas or a chloride gas, and for example, the fluoride gas may include SF₆, CHF₃, CF₄, or a mixture thereof, and the chloride gas may include Cl₂, BCl₃, or a mixture thereof.

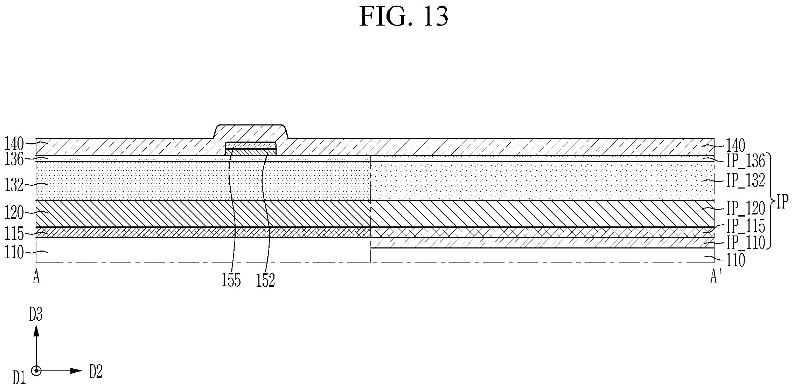

Referring to FIG. 13, a first protective layer 140 is formed on the barrier layer 136, the gate semiconductor layer 152, and the gate electrode 155.

The first protective layer 140 may be formed using a deposition process. The first protective layer 140 may include an insulating material. For example, the first protective layer 140 may include a material such as SiO₂, SiN, SiON, or Al₂O₃.

The first protective layer 140 is shown as a single layer, but may be composed of multiple layers in some cases. In some examples, the first protective layer 140 may be formed by sequentially depositing different materials. Alternatively, the first protective layer 140 may be formed of several layers with different characteristics by using the same material and varying deposition conditions. In particular, the portion of the first protective layer 140 adjacent to the barrier layer 136 may be made of an insulating material of much higher quality than other portions. This is to prevent electrons forming a channel from being trapped in the channel layer 132 under the barrier layer 136. The portion of the first protective layer 140 that is in contact with the barrier layer 136 may be made of SiO₂.

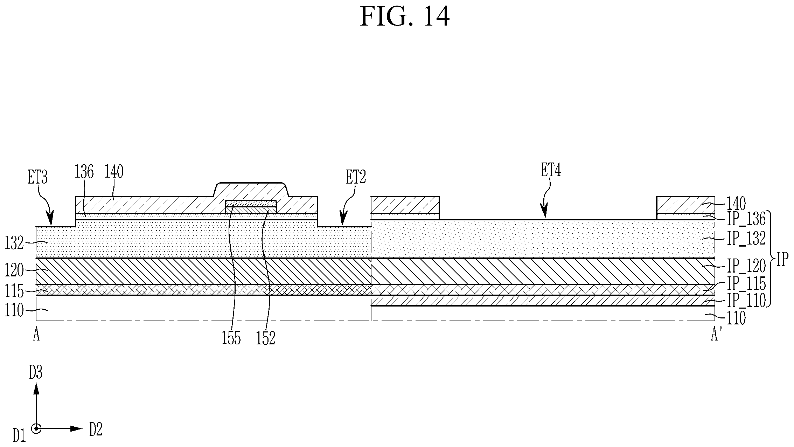

Referring to FIG. 14, the first protective layer 140 is etched to form second to fourth recesses ET2, ET3, and ET4.

For example, the first protective layer 140 may be patterned using a photoresist. A second recess ET2 may be formed at a location where a source electrode 173 is to be formed, a third recess ET3 may be formed at a location where a drain electrode 175 is to be formed, and a fourth recess ET4 may be formed at a location where a crack propagation prevention structure CS is to be formed.

In the process of forming the second to fourth recesses ET2, ET3, and ET4, not only the first protective layer 140, but also the barrier layer 136, the fifth ion implant layer IP_136, and a portion of the upper surface of the channel layer 132 may be patterned together.

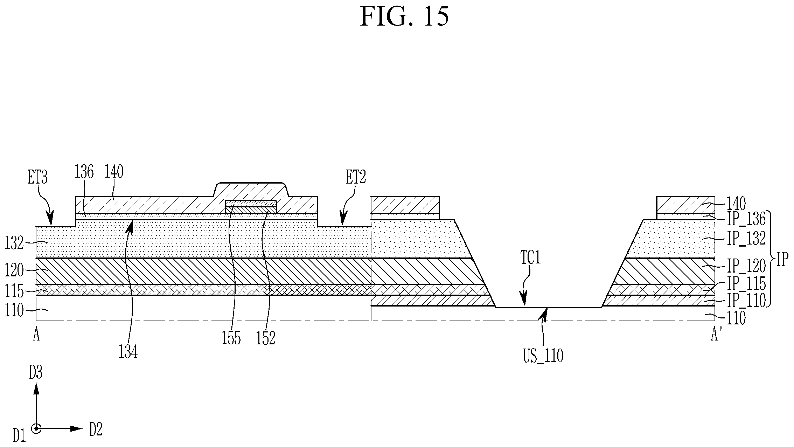

The first metal liner 191 of the crack propagation prevention structure CS by the fourth recess ET4 may have first upper extension portions 191_U. However, the present inventive concept is not limited to this, and the fourth recess ET4 may not be formed, and only the first trench (TC1 of FIG. 15) described later may be formed.

Referring to FIG. 15, a first trench TC1 is formed that penetrates the ion implant region IP and exposes a portion of the upper surface US_110 of the substrate 110.

The first trench TC1 may be formed by etching the fourth ion implant layer IP_132 exposed by the fourth recess ET4. In the process of forming the first trench TC1, not only the fourth ion implant layer IP_132 but also the first to third ion implant layers IP_110, IP_115, and IP_120 may be etched together.

For example, the first trench TC1 is formed to penetrate the ion implant region IP and expose a portion of the upper surface US_110 of the substrate 110. Accordingly, the ion implant region IP can form side walls of the first trench TC1, the upper surface US_110 of the substrate 110 can form a lower bottom surface of the first trench TC1, and the upper surface of the channel layer 132 exposed by the fourth recess ET4 can form an upper bottom surface of the first trench TC1.

The side walls of the first trench TC1 may be formed to have a slope. For example, in a cross-section cut perpendicular to the first direction D1 (for example, FIG. 15), the angle formed between the lower bottom surface and the side wall of the first trench TC1 may be greater than about 90°, greater than or equal to about 95°, for example, greater than or equal to about 100°, greater than or equal to about 105°, greater than or equal to about 110°, greater than or equal to about 115°, greater than or equal to about 120°, or greater than or equal to about 125°, and may be less than or equal to about 130°, for example, less than or equal to about 125°, less than or equal to about 120°, less than or equal to about 115°, less than or equal to about 110°, less than or equal to about 105°, or less than or equal to about 100°, and may be about 95° to about 130°.

In some embodiments, the first trench TC1 may be formed before the ion implant region IP is formed. For example, in FIG. 9, after sequentially forming a seed layer 115, a buffer layer 120, a channel layer 132, a barrier layer 136, and a gate semiconductor material layer 152_L on a substrate 110, a first trench TC1 may be formed before forming an ion implant region IP in FIG. 10. Thereafter, an ion implant region IP may be formed in the seed layer 115, buffer layer 120, channel layer 132, barrier layer 136, and gate semiconductor material layer 152_L exposed by the first trench TC1. In this case, the first protective layer 140 in FIG. 8 may extend to the side wall and lower bottom surface of the first trench TC1.

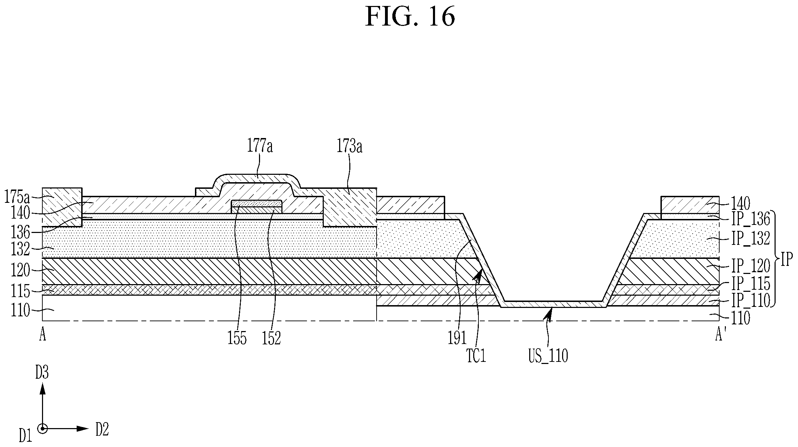

Referring to FIG. 16, a lower source electrode 173a is formed in the second recess ET2, a lower drain electrode 175a is formed in the third recess ET3, and a first metal liner 191 is formed in the first trench TC1. In some examples, the first field dispersion layer 177a may be formed together.

For example, a metal material layer is formed to fill the second recess ET2 and the third recess ET3 and cover the upper surface of the first protective layer 140 and the first trench TC1. The metal material layer may be formed using a deposition process, for example, electron beam evaporation (E-beam evaporation), sputtering, physical vapor deposition (PVD), thermal chemical vapor deposition (thermal CVD), low pressure chemical vapor deposition (LP-CVD), plasma enhanced chemical vapor deposition (PE-CVD), or atomic layer deposition (ALD). Thereafter, a metal material layer is patterned using a photoresist to form a lower source electrode 173a, a lower drain electrode 175a, a first metal liner 191, and a first field dispersion layer 177a. Etching of the metal material layer may be performed by dry etching using an etching gas.

For example, the lower source electrode 173a and the lower drain electrode 175a may be in ohmic contact with the channel layer 132. The region in contact with the lower source electrode 173a and the lower drain electrode 175a within the channel layer 132 may be doped at a relatively high concentration compared to other regions. For example, the channel layer 132 may be doped by an ion implant process, an annealing process, etc. However, it is not limited to this, and the doping process of the channel layer 132 may be performed through various other processes. The doping process of the channel layer 132 may be performed before forming the lower source electrode 173a and the lower drain electrode 175a. In some cases, the channel layer 132 may not be doped.

Referring to FIG. 17, a metal silicide layer SC may be formed between the upper surface US_110 of the substrate 110 and the first metal liner 191.

For example, a metal silicide layer SC may be formed by depositing a first metal liner 191 on an upper surface US_110 of a substrate 110 and then heat-treating at a temperature of about 550 °C to about 700 °C.

The first metal liner 191 may include a metal capable of forming a metal silicide with Si of the substrate 110. For example, the first metal liner 191 may include titanium (Ti), tantalum (Ta), tungsten (W), nickel (Ni), cobalt (Co), molybdenum (Mo), or a combination thereof. The metal silicide layer SC may include titanium silicide, tantalum silicide, tungsten silicide, nickel silicide, cobalt silicide, molybdenum silicide, or a combination thereof.

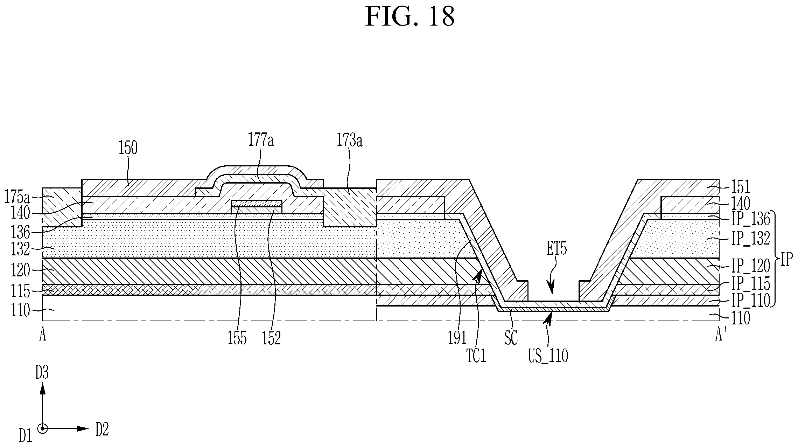

Referring to FIG. 18, a second protective layer 150 is formed on the first protective layer 140 and the first field dispersion layer 177a, and a first insulating liner 151 is formed on the first metal liner 191.

For example, an insulating material layer is formed on the first protective layer 140, the lower source electrode 173a, the lower drain electrode 175a, the first field dispersion layer 177a, and the first metal liner 191. The insulating material layer may be formed using a deposition process. For example, the insulating material layer may include a material such as SiO₂, SiN, SiON, or Al₂O₃.

Thereafter, a second protective layer 150 is formed on the first protective layer 140 and the first field dispersion layer 177a by patterning the insulating material layer, and a first insulating liner 151 is formed on the first metal liner 191. For example, the insulating material layer on the lower source electrode 173a and the lower drain electrode 175a is removed. In some examples, a portion of the insulating material layer on the first metal liner 191 may also be removed to form a fifth recess ET5.

In some embodiments, the surface of the first insulating liner 151 may be planarized using a process such as etch back or CMP (Chemical Mechanical Polishing) before forming the first insulating liner 151 and forming the fifth recess ET5.

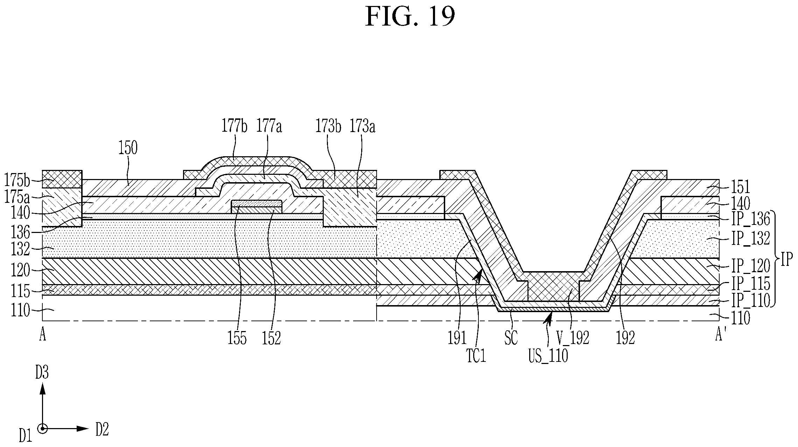

Referring to FIG. 19, an intermediate source electrode 173b is formed on a lower source electrode 173a, an intermediate drain electrode 175b is formed on a lower drain electrode 175a, and a second metal liner 192 is formed on a first insulating liner 151 of a first trench TC1. In such examples, a second field dispersion layer 177b may be formed together, and a first via V_192 may be formed in the fifth recess ET5.

For example, a metal material layer is formed on the second protective layer 150, the lower source electrode 173a, the lower drain electrode 175a, the first insulating liner 151, and the first metal liner 191. The metal material layer may be formed using a deposition process, for example, electron beam evaporation (E-beam evaporation), sputtering, physical vapor deposition (PVD), thermal chemical vapor deposition (thermal CVD), low pressure chemical vapor deposition (LP-CVD), plasma enhanced chemical vapor deposition (PE-CVD), or atomic layer deposition (ALD). Thereafter, a metal material layer is patterned using a photoresist to form an intermediate source electrode 173b, an intermediate drain electrode 175b, a second metal liner 192, and a second field dispersion layer 177b. In some examples, the metal liner filling the fifth recess ET5 becomes the first via V_192. Etching of the metal material layer can be performed by dry etching using an etching gas.

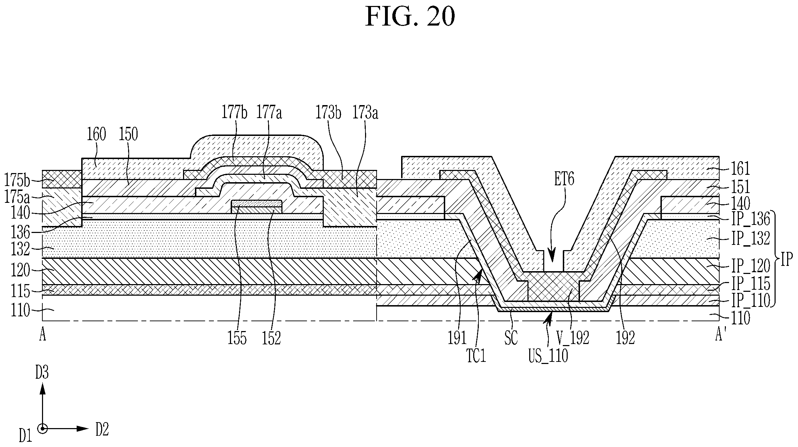

Referring to FIG. 20, a third protective layer 160 is formed on the second protective layer 150 and the second field dispersion layer 177b, and a second insulating liner 161 is formed on the first insulating liner 151 and the second metal liner 192.

For example, an insulating material layer is formed on the second protective layer 150, the intermediate source electrode 173b, the intermediate drain electrode 175b, the second field dispersion layer 177b, the first insulating liner 151, and the second metal liner 192. The insulating material layer may be formed using a deposition process. For example, the insulating material layer may include a material such as SiO₂, SiN, SiON, or Al₂O₃.

Thereafter, a third protective layer 160 is formed on the second protective layer 150 and the second field dispersion layer 177b by patterning the insulating material layer, and a second insulating liner 161 is formed on the first insulating liner 151 and the second metal liner 192. For example, the insulating material layer on the intermediate source electrode 173b and the intermediate drain electrode 175b is removed. In some examples, a portion of the insulating material layer on the second metal liner 192 may also be removed to form a sixth recess ET6.

In some embodiments, the surface of the second insulating liner 161 may be planarized using a process such as etch back or chemical mechanical polishing (CMP) before forming the second insulating liner 161 and forming the sixth recess ET6.

Referring again to FIG. 5, an upper source electrode 173c is formed on the intermediate source electrode 173b, an upper drain electrode 175c is formed on the intermediate drain electrode 175b, and a third metal liner 193 is formed on the second insulating liner 161 of the first trench TC1. In some examples, a third field dispersion layer 177c may be formed together, and a second via V_193 may be formed in the sixth recess ET6.

For example, a metal material layer is formed on the third protective layer 160, the intermediate source electrode 173b, the intermediate drain electrode 175b, the second insulating liner 161, and the second metal liner 192. The metal material layer may be formed using a deposition process, for example, electron beam evaporation (E-beam evaporation), sputtering, physical vapor deposition (PVD), thermal chemical vapor deposition (thermal CVD), low pressure chemical vapor deposition (LP-CVD), plasma enhanced chemical vapor deposition (PE-CVD), or atomic layer deposition (ALD). Thereafter, a metal material layer is patterned using a photoresist to form an upper source electrode 173c, an upper drain electrode 175c, a third metal liner 193, and a third field dispersion layer 177c. In some examples, the metal liner filling the sixth recess ET6 becomes the second via V_193. Etching of the metal material layer may be performed by dry etching using an etching gas.

While the inventive concept has been described in connection with what is presently considered to be practical embodiments, it is to be understood that the invention is not limited to the disclosed embodiments, but, on the contrary, is intended to cover various modifications and equivalent arrangements included within the scope of the appended claims.

Embodiments are set out in the following Clauses:
Clause 1. A semiconductor device, comprising
   a substrate,
   a channel layer on the substrate,
   a barrier layer located on the channel layer and including a material having an energy band gap different from that of the channel layer,
   a gate electrode located on the barrier layer and extending in a first direction parallel to the upper surface of the substrate,
   a gate semiconductor layer located between the barrier layer and the gate electrode,
   a source electrode and a drain electrode connected to the channel layer and spaced apart from the gate electrode in a second direction parallel to the upper surface of the substrate and perpendicular to the first direction, and
   a crack propagation prevention structure located on one side of the source electrode and connected to the source electrode, and connected to the substrate penetrating the channel layer and the barrier layer.
Clause 2.The semiconductor device of Clause 1, wherein
   the substrate has a transistor region, and an outer region surrounding the transistor region,
   the gate electrode, the source electrode, and the drain electrode are located on the transistor region of the substrate,
   the crack propagation prevention structure is located the outer region, and
   the crack propagation prevention structure surrounds the gate electrode, the source electrode, and the drain electrode.
Clause 3.The semiconductor device of Clause 1 or Clause 2, wherein
   the crack propagation prevention structure includes
   a first metal liner covering both side surfaces of the channel layer and the upper surface of the substrate;
   a first insulating liner covering the first metal liner, and
   a second metal liner covering the first insulating liner.
Clause 4.The semiconductor device of Clause 3, wherein
   the crack propagation prevention structure further includes
   a second insulating liner covering the second metal liner, and
   a third metal liner covering the second insulating liner.
Clause 5.The semiconductor device of Clause 4, wherein
   the first metal liner is connected to the substrate,
   the third metal liner is connected to the source electrode, and
   the crack propagation prevention structure includes
      a first via penetrating the first insulating liner and connecting the first metal liner and the second metal liner, and
      a second via including a second insulating liner penetrating the second metal liner and connecting the second metal liner and the third metal liner.
Clause 6.The semiconductor device of Clause 5, wherein
   in a cross-section cut perpendicular to the first direction in which the gate electrode extends, a width of the first via in the second direction is larger than a width of the second via in the second direction.
Clause 7.The semiconductor device of Clause 5 or Clause 6, wherein the semiconductor device further includes
   a first protective layer covering the gate electrode,
   a first field dispersion layer located on the first protective layer, connected to the source electrode, and overlapping the gate electrode in the third direction;
   a second protective layer located on the first protective layer;
   a second field dispersion layer located between the first protective layer and the second protective layer, connected to the source electrode, and overlapping the gate electrode in the third direction;
   a third protective layer on the second protective layer, and
   a third field dispersion layer located between the second protective layer and the third protective layer, connected to the source electrode, and overlapping the gate electrode in the third direction.
Clause 8.The semiconductor device of Clause 7, wherein
   the source electrode includes
   a lower source electrode connected to the first field dispersion layer,
   a intermediate source electrode located on the lower source electrode and connected to the second field dispersion layer, and
   an upper source electrode located on the intermediate source electrode and connected to the third field dispersion layer and the third metal liner.
Clause 9.The semiconductor device of any of Clauses 5-8, wherein
   the first metal liner has
   a first lower extension portion in contact with the upper surface of the substrate;
   first upper extension portions each in contact with the upper surfaces of the channel layer located on both sides of the crack propagation prevention structure, and
   first side wall portions respectively in contact with the side surfaces of the channel layer located on both sides of the crack propagation prevention structure and connecting between the first lower extension portion and the first upper extension portion;
   the second metal liner has
   a second lower extension portion on the first lower extension portion;
   second upper extension portions each located on the first upper extension portions, and
   second side wall portions connecting the second lower extension portion and the second upper extension portions; and the third metal liner has
   a third lower extension portion on the second lower extension portion,
   third upper extension portions each located on the second upper extension portions, and
   third side wall portions connecting between the third lower extension portion and the third upper extension portions.
Clause 10.The semiconductor device of Clause 9, wherein
   in a cross-section cut perpendicular to the first direction in which the gate electrode extends,
   a width of the second lower extension portion in the second direction is smaller than a width of the first lower extension portion in the second direction,
   a width of the third lower extension portion in the second direction is smaller than a width of the second lower extension portion in the second direction,
   a width of the second upper extension portion in the second direction is greater than a width of the first upper extension portion in the second direction, and
   a width of the third upper extension portion in the second direction is greater than a width of the second upper extension portion in the second direction.
Clause 11.The semiconductor device of Clause 9 or Clause 10, wherein
   the first via is located between the first lower extension portion and the second lower extension portion,
   the second via is located between the second lower extension portion and the third lower extension portion.
Clause 12.The semiconductor device of Clause 9 or Clause 10, wherein
   the first via is located between the first upper extension portion and the second upper extension portion, and
   the second via is located between the second upper extension portion and the third upper extension portion.
Clause 13.The semiconductor device of any of Clauses 9-12, wherein
   in a cross-section cut perpendicular to the first direction in which the gate electrode extends, an angle formed by the first lower extension portion of the first metal liner and the first sidewall portion is about 95° to about 130°.
Clause 14.The semiconductor device of any preceding Clause, wherein
   in a cross-section cut perpendicular to the first direction in which the gate electrode extends, the crack propagation prevention structure has a convex shape toward the substrate.
Clause 15.The semiconductor device of Clause 14, wherein
   the crack propagation prevention structure has a first recess extending along the crack propagation prevention structure between the third lower extension portion and the third side wall portions,
   in a cross-section cut perpendicular to the first direction in which the gate electrode extends, the crack propagation prevention structure has a "U" or "V" shape.
Clause 16.The semiconductor device of any preceding Clause, wherein
   the substrate has
   a transistor region, and an outer region surrounding the transistor region,
   the gate electrode, the source electrode, and the drain electrode are located on the transistor region of the substrate,
   the crack propagation prevention structure is located the outer region,
   a portion of the upper surface of the substrate and the channel layer located on the outer region of the substrate further include an ion implant region,
   the crack propagation prevention structure penetrates the ion implant region of the channel layer, and
   the crack propagation prevention structure separates the ion implant region located on one side of the crack propagation prevention structure and located between the source electrode and the crack propagation prevention structure, and the ion implant region located on the other side of the crack propagation prevention structure.
Clause 17.The semiconductor device of any preceding Clause, wherein
   the semiconductor device further includes
   a protective layer covering the gate electrode, and
   a field dispersion layer located on the protective layer, connected to the source electrode, and overlapping the gate electrode in the third direction,

   the crack propagation prevention structure includes
      an insulating liner covering both side surfaces of the channel layer and the upper surface of the substrate,
      a metal liner covering the insulating liner, and
      a via that penetrates the insulating liner and connects the metal liner and the substrate, and
   the metal liner is connected to the source electrode and the field dispersion layer.
Clause 18. A semiconductor device, comprising
   a substrate,
   a channel layer on the substrate,
   a barrier layer located on the channel layer and including a material having an energy band gap different from that of the channel layer,
   a gate electrode located on the barrier layer and extending in a first direction parallel to the upper surface of the substrate,
   a gate semiconductor layer located between the barrier layer and the gate electrode,
   a source electrode and a drain electrode connected to the channel layer and spaced apart from the gate electrode in a second direction parallel to the upper surface of the substrate and perpendicular to the first direction,
   a protective layer covering the gate electrode,
   a field dispersion layer located on the protective layer, connected to the source electrode, and overlapping the gate electrode in the third direction, and
   a crack propagation prevention structure located on one side of the source electrode and connected to the source electrode, and connected to the substrate penetrating the channel layer and the barrier layer,
   wherein the crack propagation prevention structure includes a metal liner covering both side surfaces of the channel layer and the upper surface of the substrate, and
   the metal liner is connected to the source electrode and the field dispersion layer.
Clause 19.A semiconductor device, comprising
   a substrate,
   a channel layer on the substrate,
   a barrier layer located on the channel layer and including a material having an energy band gap different from that of the channel layer,
   a gate electrode located on the barrier layer and extending in a first direction parallel to the upper surface of the substrate,
   a gate semiconductor layer located between the barrier layer and the gate electrode,
   a source electrode and a drain electrode connected to the channel layer and spaced apart from the gate electrode in a second direction parallel to the upper surface of the substrate and perpendicular to the first direction, and
   a crack propagation prevention structure located on one side of the source electrode and connected to the source electrode, and connected to the substrate penetrating the channel layer and the barrier layer,
   wherein the crack propagation prevention structure includes a metal liner covering both side surfaces of the channel layer and the upper surface of the substrate, and
   the crack propagation prevention structure further includes a metal silicide layer between the substrate and the metal liner of the crack propagation prevention structure.
Clause 20.The semiconductor device of Clause 19, wherein
   the metal liner includes titanium (Ti), tantalum (Ta), tungsten (W), nickel (Ni), cobalt (Co), molybdenum (Mo), or a combination thereof, and
   the metal silicide layer includes titanium silicide, tantalum silicide, tungsten silicide, nickel silicide, cobalt silicide, molybdenum silicide, or a combination thereof.

## Claims

1. A semiconductor device, comprising:
a substrate;
a channel layer on the substrate, the channel layer including a first material;
a barrier layer located on the channel layer, the barrier layer including a second material having an energy band gap different from that of the first material,
a gate electrode located on the barrier layer and extending in a first direction parallel to an upper surface of the substrate;
a gate semiconductor layer located between the barrier layer and the gate electrode;
a source electrode connected to the channel layer and spaced apart from the gate electrode in a second direction parallel to the upper surface of the substrate and perpendicular to the first direction;
a drain electrode connected to the channel layer and spaced apart from the gate electrode in the second direction; and
a crack propagation prevention structure located on a side of the source electrode and connected to the source electrode, and penetrating through the channel layer and the barrier layer into the substrate.

2. The semiconductor device of claim 1, wherein
the substrate has a transistor region and an outer region surrounding the transistor region,
the gate electrode, the source electrode, and the drain electrode are located on the transistor region of the substrate,
the crack propagation prevention structure is located on the outer region, and
the crack propagation prevention structure surrounds the gate electrode, the source electrode, and the drain electrode.

3. The semiconductor device of claim 1 or claim 2, wherein the crack propagation prevention structure includes
a first metal liner covering side surfaces of the channel layer and a portion of the upper surface of the substrate,
a first insulating liner covering a portion of the first metal liner, and
a second metal liner covering a portion of the first insulating liner.

4. The semiconductor device of claim 3, wherein the crack propagation prevention structure further includes
a second insulating liner covering a portion of the second metal liner, and
a third metal liner covering a portion of the second insulating liner.

5. The semiconductor device of claim 4, wherein
the first metal liner penetrates the substrate,
the third metal liner is connected to the source electrode, and
the crack propagation prevention structure includes
a first via penetrating through the first insulating liner and connecting the first metal liner and the second metal liner, and
a second via penetrating through the second insulating liner and connecting the second metal liner and the third metal liner.

6. The semiconductor device of claim 5, wherein
in a cross-section perpendicular to the first direction in which the gate electrode extends, a width of the first via in the second direction is larger than a width of the second via in the second direction.

7. The semiconductor device of claim 5 or claim 6, wherein
the semiconductor device further includes
a first protective layer covering the gate electrode,
a first field dispersion layer located on the first protective layer, connected to the source electrode, and overlapping the gate electrode in a third direction,
a second protective layer located on the first protective layer,
a second field dispersion layer located on the second protective layer, connected to the source electrode, and overlapping the gate electrode in the third direction,
a third protective layer on the second protective layer, and
a third field dispersion layer located on the third protective layer, connected to the source electrode, and overlapping the gate electrode in the third direction, and,
wherein the source electrode includes:
a lower source electrode connected to the first field dispersion layer,
an intermediate source electrode located on the lower source electrode and connected to the second field dispersion layer, and
an upper source electrode located on the intermediate source electrode and connected to the third field dispersion layer and the third metal liner.

8. The semiconductor device of any of claims 5-7, wherein
the first metal liner has
a first lower extension portion in contact with the upper surface of the substrate,
first upper extension portions in contact with upper surfaces of the channel layer located on opposing sides of the crack propagation prevention structure, and
first side wall portions in contact with side surfaces of the channel layer located on opposing sides of the crack propagation prevention structure and connecting between the first lower extension portion and the first upper extension portion;
the second metal liner has
a second lower extension portion on the first lower extension portion;
second upper extension portions located on the first upper extension portions, and
second side wall portions connecting the second lower extension portion and the second upper extension portions; and
the third metal liner has
a third lower extension portion on the second lower extension portion,
third upper extension portions located on the second upper extension portions, and
third side wall portions connecting between the third lower extension portion and the third upper extension portions.

9. The semiconductor device of claim 8, wherein
in a cross-section perpendicular to the first direction in which the gate electrode extends,
a width of the second lower extension portion in the second direction is smaller than a width of the first lower extension portion in the second direction,
a width of the third lower extension portion in the second direction is smaller than a width of the second lower extension portion in the second direction,
a width of one or more the second upper extension portions in the second direction is greater than a width of one or more the first upper extension portions in the second direction, and
a width of one or more the third upper extension portions in the second direction is greater than a width of the one or more second upper extension portions in the second direction.

10. The semiconductor device of claim 8 or claim 9, wherein
the first via is located between the first lower extension portion and the second lower extension portion,
the second via is located between the second lower extension portion and the third lower extension portion.

11. The semiconductor device of claim 8 or claim 9, wherein
the first via is located between one of the first upper extension portions and one of the second upper extension portions, and
the second via is located between one of the second upper extensions portion and one of the third upper extension portions.

12. The semiconductor device of any of claims 8-11, wherein
in a cross-section perpendicular to the first direction in which the gate electrode extends, an angle formed by the first lower extension portion of the first metal liner and each of the first side wall portions is between 95° and 130°.

13. The semiconductor device of any preceding claim, wherein
in a cross-section perpendicular to the first direction in which the gate electrode extends, the crack propagation prevention structure has a convex shape toward the substrate, and,
wherein:
the crack propagation prevention structure has a first recess extending along the crack propagation prevention structure, and
in a cross-section perpendicular to the first direction in which the gate electrode extends, the crack propagation prevention structure has a "U" or "V" shape.

14. The semiconductor device of any preceding claim, wherein
the substrate has
a transistor region, and an outer region surrounding the transistor region,
the gate electrode, the source electrode, and the drain electrode are located on the transistor region of the substrate,
the crack propagation prevention structure is located on the outer region,
a portion of the upper surface of the substrate and the channel layer located on the outer region of the substrate further include an ion implant region,
the crack propagation prevention structure penetrates the ion implant region of the channel layer, and
the crack propagation prevention structure separates the ion implant region located on a first side of the crack propagation prevention structure into a first portion of the ion implant region located between the source electrode and the crack propagation prevention structure, and a second portion of the ion implant region located on an opposite, second side of the crack propagation prevention structure.

15. The semiconductor device of any preceding claim, wherein
the semiconductor device further includes
a protective layer covering the gate electrode, and
a field dispersion layer located on the protective layer, connected to the source electrode, and overlapping the gate electrode in a third direction perpendicular to the upper surface of the substrate and perpendicular to the second direction,
the crack propagation prevention structure includes
an insulating liner covering side surfaces of the channel layer and a portion of the upper surface of the substrate,
a metal liner covering a portion of the insulating liner, and
a via that penetrates through the insulating liner and connects the metal liner and the substrate, and
the metal liner is connected to the source electrode and the field dispersion layer.
